(19) Europäisches Patentamt
European Patent Office
Office européen des brevets

(11) EP 3 809 802 A1

(12) EUROPEAN PATENT APPLICATION
published in accordance with Art. 153(4) EPC

(43) Date of publication:
**21.04.2021 Bulletin 2021/16**

(21) Application number: **19819078.7**

(22) Date of filing: **06.06.2019**

(51) Int Cl.:
***H05B 33/10*** *(2006.01)* ***H01L 51/50*** *(2006.01)*

(86) International application number:
**PCT/JP2019/022476**

(87) International publication number:
**WO 2019/239998 (19.12.2019 Gazette 2019/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.06.2018 JP 2018111988**

(71) Applicant: **SUMITOMO CHEMICAL COMPANY LIMITED**
**Chuo-ku**
**Tokyo 104-8260 (JP)**

(72) Inventors:
- **KAKIMOTO, Hidenobu**
  **Osaka-shi, Osaka 554-8558 (JP)**
- **OHTSUKA, Susumu**
  **Osaka-shi, Osaka 554-8558 (JP)**

(74) Representative: **J A Kemp LLP**
**14 South Square**
**Gray's Inn**
**London WC1R 5JJ (GB)**

# (54) ORGANIC ELECTROLUMINESCENCE ELEMENT

(57) The present invention has an object of providing an organic EL device excellent particularly in luminance life among properties of an organic EL device. The present invention relates to an organic EL device comprising an organic EL material and a solvent A having a boiling point under 1 atom of 250°C or higher, wherein the proportion $X_A$ (μg/cm$^3$) of the content (pg) of the solvent A to the volume (cm$^3$) of the organic EL material in the organic EL device satisfies the formula (1):

$$5 < X_A \leq 2650 \quad (1),$$

and a production method thereof.

EP 3 809 802 A1

# Description

## Technical Field

The present invention relates to an organic electroluminescent device.

## Background Art

Organic electroluminescent devices (hereinafter, described as "organic EL device") can be suitably used for display and illumination applications because of high light emission efficiency and low driving voltage, and research and development thereof have been actively conducted. It is possible to form a light emitting layer using discharge type application methods typified by an inkjet printing method, by using a composition containing a soluble luminescent compound used in a light emitting layer of an organic EL device, and a solvent. Additionally, it is possible to produce a large area organic EL device in a simple process, by forming a light emitting layer using a discharge type application method. Accordingly, various soluble luminescent compounds and solvents have been studied.
Patent Document 1 describes an investigation to improve device properties by improving soluble luminescent compounds, but sufficient device properties have not been obtained yet.
Further, in order to form a uniform light emitting layer in the case of manufacturing an organic EL device using an application method, the drying behavior of an ink needs to be precisely controlled, and in general, the slow drying property of slowly drying the ink is required. Hence, a solvent containing a high boiling point solvent is used as the solvent for the ink. However, the influence of the high boiling point solvent exerted on the properties of the organic EL device, when the high boiling point solvent remains in the light emitting material, has not been clarified.

## Prior Art Document

### Patent Document

Patent Document 1: Japanese Unexamined Patent Application Publication (JP-A) No. 2006-128325

## Summary of the Invention

### Problem to be Solved by the Invention

A number of luminescent compounds and solvents suitable for the above-described application method have been studied until now, but the device properties are not sufficient yet, thus, a further improvement in the device properties is required.
The present invention has an object of providing an organic EL device excellent particularly in luminance life among the properties of the organic EL device.

### Means for Solving the Problem

In order to solve the above-described problem, the present inventors have investigated how the content (residual amount) of the high boiling point solvent in the organic EL device affects the luminance life of the organic EL device. As a result, it was found that the proportion of the content (residual amount) of the high boiling point solvent to the volume of the organic EL material in the organic EL device correlates with the luminance life of the organic EL device. Based on such findings, further studies have been carried out to complete the present invention.
That is, the present invention provides the following organic EL device and production method thereof.

[1] An organic EL device comprising an organic EL material and a solvent A having a boiling point under 1 atom of 250°C or higher, wherein the proportion $X_A$ ($\mu$g/cm$^3$) of the content ($\mu$g) of the solvent A to the volume (cm$^3$) of the organic EL material in the organic EL device satisfies the formula (1):

$$5 < X_A \leq 2650 \qquad (1).$$

[2] The organic EL device according to [1], wherein the organic EL device has a substrate, an electrode and two or more organic EL material layers, and at least one organic EL material layer contains the solvent A.

[3] The organic EL device according to [2], wherein the organic EL material layer contains a hole injection layer, a hole transporting layer and a light emitting layer, and the solvent A is contained at least in the light emitting layer.
[4] The organic EL device according to any one of [1] to [3], wherein the solvent A is at least one selected from the group consisting of a hydrocarbon solvent, an alcohol solvent, an ester solvent, a ketone solvent, an ether solvent, a solvent containing a nitrogen atom, and a solvent containing a sulfur atom.
[5] The organic EL device according to any one of [1] to [4], wherein the organic EL material is at least one selected from the group consisting of a compound represented by the formula (Y), a compound represented by the formula (H-1) and a compound represented by the formulae (Ir-1) to (Ir-5).
[6] A method of producing an organic EL device having an electrode and two or more organic EL material layers on a substrate, wherein a composition comprising a solvent containing a solvent A having a boiling point under 1 atom of 250°C or higher and an organic EL material is applied and dried to form one or more organic EL material layers, and the proportion $X_A$ ($\mu g/cm^3$) of the content (pg) of the solvent A in the organic EL device to the volume ($cm^3$) of the organic EL material in the organic EL device is adjusted so as to satisfy the formula (1):

$$5 < X_A \leq 2650 \quad (1).$$

Effect of the Invention

According to the present invention, an organic EL device excellent in luminance life can be provided.

Modes for Carrying Out the Invention

Suitable embodiments of the present invention will be described in detail below.

1. Explanation of common terms

Terms commonly used in the present invention have the following meanings unless otherwise stated.
"Me" represents a methyl group, "Et" represents an ethyl group, "Bu" represents a butyl group, "i-Pr" represents an isopropyl group, and "t-Bu" represents a tert-butyl group.
In the formulae representing metal complexes, the solid line representing a bond to the central metal denotes a covalent bond or a coordination bond.
The "polymer compound" means a polymer having molecular weight distribution and having a polystyreneequivalent number-average molecular weight of $1 \times 10^3$ to $1 \times 10^8$.
The "low molecular weight compound" means a compound having no molecular weight distribution and having a molecular weight of $1 \times 10^4$ or less.
The "constitutional unit" means a unit occurring once or more times (further, twice or more times) in the polymer compound.
The "organic EL material" means a material used in an organic EL device such as a hole injection material, a hole transporting material, a light emitting material, an electron transporting material, an electron injection material and the like, excepting a substrate, an anode and a cathode. The foregoing materials are usually materials formed by an application method. The foregoing materials can be varied depending on the structure of the device. The above-described organic EL materials may each be a low molecular weight material (low molecular weight compound) or a polymer material (polymer compound).
The "alkyl group" may be any of linear and branched. The number of carbon atoms of the linear alkyl group is usually 1 to 50, and the number of carbon atoms of the branched alkyl group is usually 3 to 50. The "alkyl group" includes, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group. The "alkyl group" optionally has a substituent.
The number of carbon atoms of the "cycloalkyl group" is usually 3 to 50. The "cycloalkyl group" includes, for example, a cyclohexyl group, a cyclohexylmethyl group and a cyclohexylethyl group. The "cycloalkyl group" optionally has a substituent.
The "aryl group" denotes an atomic group remaining after removing from an aromatic hydrocarbon one hydrogen atom directly bonding to a carbon atom constituting the ring. The number of carbon atoms of the aryl group is usually 6 to 60. The "aryl group" includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group. The "aryl group" optionally has a substituent.

The "alkoxy group" may be any of linear and branched. The number of carbon atoms of the linear alkoxy group is usually 1 to 40, and the number of carbon atoms of the branched alkoxy group is usually 3 to 40. The "alkoxy group" includes, for example, a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group. The "alkoxy group" optionally has a substituent.

The number of carbon atoms of the "cycloalkoxy group" is usually 3 to 40. The "cycloalkoxy group" includes, for example, a cyclohexyloxy group. The "cycloalkoxy group" optionally has a substituent.

The number of carbon atoms of the "aryloxy group" is usually 6 to 60. The "aryloxy group" includes, for example, a phenoxy group, a 1-naphthyloxy group, a 2-naphthyloxy group, a 1-anthracenyloxy group, a 9-anthracenyloxy group and a 1-pyrenyloxy group. The "aryloxy group" optionally has a substituent.

The "p-valent heterocyclic group"(p represents an integer of 1 or more) denotes an atomic group remaining after removing from a heterocyclic compound p hydrogen atoms among hydrogen atoms bonding directly to carbon atoms or hetero atoms constituting the ring.

The number of carbon atoms of the monovalent heterocyclic group is usually 2 to 60.

The monovalent heterocyclic group includes, for example, a thienyl group, a pyrrolyl group, a furyl group, a pyridyl group, a piperidinyl group, a quinolinyl group, an isoquinolinyl group, a pyrimidinyl group and a triazinyl group. The "monovalent heterocyclic group" optionally has a substituent.

The "halogen atom" denotes a fluorine atom, a chlorine atom, a bromine atom or an iodine atom.

The "amino group" optionally has a substituent. The "substituted amino group" includes, for example, a dialkylamino group, a dicycloalkylamino group and a diarylamino group. Specific examples thereof include a dimethylamino group, a diethylamino group, a diphenylamino group, a bis(4-methylphenyl)amino group, a bis(4-tert-butylphenyl)amino group and a bis(3,5-di-tert-butylphenyl)amino group.

The "alkenyl group" may be any of linear and branched. The number of carbon atoms of the linear alkenyl group is usually 2 to 30, and the number of carbon atoms of the branched alkenyl group is usually 3 to 30. The "alkenyl group" includes, for example, a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group. The "alkenyl group" optionally has a substituent.

The number of carbon atoms of the "cycloalkenyl group" is usually 3 to 30. The "cycloalkenyl group" optionally has a substituent.

The "alkynyl group" may be any of linear and branched. The number of carbon atoms of the alkynyl group is usually 2 to 20, and the number of carbon atoms of the branched alkynyl group is usually 4 to 30. The "alkynyl group" includes, for example, an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group. The "alkynyl group" optionally has a substituent.

The number of carbon atoms of the "cycloalkynyl group" is usually 4 to 30. The "cycloalkynyl group" optionally has a substituent.

The "arylene group" denotes an atomic group remaining after removing from an aromatic hydrocarbon two hydrogen atoms directly bonding to carbon atoms constituting the ring. The number of carbon atoms of the arylene group is usually 6 to 60. The "arylene group" includes, for example, a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group and a chrysenediyl group, including a group in which multiple of these groups are bonded. The "arylene group" optionally has a substituent.

The number of carbon atoms of the "divalent heterocyclic group" is usually 2 to 60. The "divalent heterocyclic group" includes divalent groups obtained by removing from, for example, pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms bonding directly to carbon atoms or hetero atoms constituting the ring, including a group in which multiple of these groups are bonded. The "divalent heterocyclic group" optionally has a substituent.

The "crosslinking group" is a group capable of generating a new bond by subjecting to heating, ultraviolet irradiation, near-ultraviolet irradiation, visible light irradiation, infrared irradiation, radical reaction and the like. The crosslinking group is preferably a group represented by any of the formulae (B-1) to (B-17), and the foregoing groups optionally have a substituent.

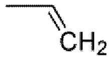 (B-1) 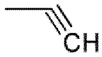 (B-2) 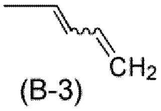 (B-3) 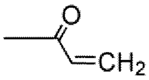 (B-4) 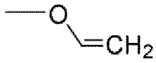 (B-5) 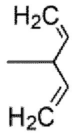 (B-6) 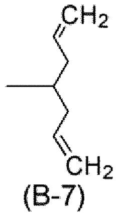 (B-7) 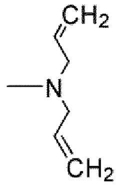 (B-8)

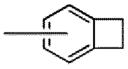 (B-9) 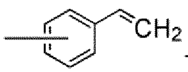 (B-10) 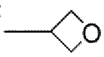 (B-11) 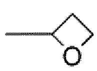 (B-12) 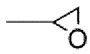 (B-13) 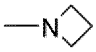 (B-14) 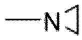 (B-15) 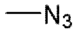 (B-16) 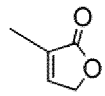 (B-17)

The "substituent" represents, for example, a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group or a cycloalkynyl group. The substituent may be a crosslinking group.

2. Organic EL device

<Organic EL device>

The organic EL device of the present invention contains an organic EL material and a solvent A having a boiling point under 1 atom of 250°C or higher, wherein the proportion $X_A$ ($\mu$g/cm$^3$) of the content (pg) of the solvent A to the volume (cm$^3$) of the organic EL material in the organic EL device satisfies the formula (1):

$$5 < X_A \leq 2650 \qquad (1).$$

The volume (cm$^3$) of the organic EL material in the organic EL device means the total volume of organic EL materials contained in the organic EL device. This volume can be calculated from the light emission area and the thickness as described later.

The content ($\mu$g) of the solvent A in the organic EL device means the total volume of the solvents A contained in the organic EL device. This content of the solvent A can be measured using, for example, a head space gas chromatography method describer later.

The lower limit value of $X_A$ is preferably 10, more preferably 14 and further preferably 18. The upper limit value of $X_A$ is preferably 2600, more preferably 2400, further preferably 2000 and particularly preferably 1800. The lower limit values and the upper limit values can each be combined arbitrarily. When two or more solvents A are contained in the organic EL device, the sum of the respective contents satisfies the formula (1).

Regarding the other suitable ranges of $X_A$, the lower limit value is preferably 10, more preferably 14 and further preferably 18, and the upper limit value is preferably 150, more preferably 100, further preferably 80, particularly preferably 70, especially preferably 65 and especially more preferably 60. These apply well when the organic EL material in at least one layer (preferably, light emitting layer) among organic EL material layers containing organic EL materials is composed of a polymer compound as the main component.

The phrase "when the organic EL material in at least one layer among organic EL material layers containing organic EL materials is composed of a polymer compound as the main component" means that the content of the polymer compound is larger than 50 parts by weight when the total content of organic EL materials contained in at least one layer among organic EL material layers containing organic EL materials is taken as 100 parts by weight, and it is preferably 51 parts by weight or more, and more preferably 55 parts by weight or more, and may be 70 parts by weight or more, may be 80 parts by weight or more, may be 90 parts by weight or more, may be 95 parts by weight or more, and may also be 100 parts by weight.

Regarding the other suitable ranges of $X_A$, the lower limit value is preferably 10, more preferably 50, further preferably 100 and particularly preferably 150, and the upper limit value is preferably 2600, more preferably 2400, further preferably 2000 and particularly preferably 1800. These apply well when the organic EL material in at least one layer (preferably, light emitting layer) among organic EL material layers containing organic EL materials is composed of a low

molecular weight compound as the main component.

The phrase "when the organic EL material in at least one layer among organic EL material layers containing organic EL materials is composed of a low molecular weight compound as the main component" means that the content of the low molecular weight compound is larger than 50 parts by weight when the total content of organic EL materials contained in at least one layer among organic EL material layers containing organic EL materials is taken as 100 parts by weight, and it is preferably 51 parts by weight or more, more preferably 60 parts by weight or more, further preferably 80 parts by weight or more, particularly preferably 95 parts by weight or more, and may also be 100 parts by weight.

The organic EL device has, for example, an anode, a cathode and two or more (further, three or more) organic EL material layers containing organic EL materials on a substrate. Usually, an organic EL material layer is disposed between an anode and a cathode. The organic EL material layer includes, for example, a hole injection layer, a hole transporting layer, a light emitting layer, an electron transporting layer, an electron injection layer and the like. It is preferable from the standpoint of hole injectability and hole transportability that at least one of a hole injection layer and a hole transporting layer is disposed between an anode and a light emitting layer, and it is preferable from the standpoint of electron injectability and electron transportability that at least one of an electron injection layer and an electron transporting layer is disposed between a cathode and a light emitting layer.

The organic EL material constituting each of a hole transporting layer, an electron transporting layer, a light emitting layer, a hole injection layer and an electron injection layer can be selected depending on the function of each layer, and can be selected from the group consisting of polymer compounds and low molecular weight compounds. For example, when the organic EL material contains a polymer compound as the main component, the layer constitution of the organic EL material layer includes a hole injection layer, a hole transporting layer, a light emitting layer and the like. In contrast, when the organic EL material contains a low molecular weight compound as the main component, the layer constitution of the organic EL material layer includes a hole injection layer, a hole transporting layer, a light emitting layer, an electron transporting layer, an electron injection layer and the like.

In the organic EL device, at least one layer (particularly, light emitting layer) among organic EL material layers such as a hole transporting layer, an electron transporting layer, a hole injection layer, and electron injection layer and the like contains, for example, an organic EL material selected from the group consisting of low molecular weight compounds and polymer compounds, and is usually formed by an application method from the state of a solution containing this organic EL material and a solvent including a solvent A. That is, one or more layers among a plurality of organic EL material layers contain a solvent A. Further, the organic EL material layer may contain additives such as an antioxidant and the like as needed.

<Solvent A having boiling point under 1 atom of 250°C or higher>

The solvent A having a boiling point under 1 atom of 250°C or higher (hereinafter, also described as "solvent A") is contained in the organic EL device of the present invention, specifically, contained in at least one of organic EL material layers in the organic EL device. The lower limit value of the boiling point under 1 atom of the solvent A is preferably 255°C, more preferably 260°C, further preferably 265°C, and particularly preferably 270°C. The upper limit value of the boiling point thereof is preferably 320°C, more preferably 310°C, and particularly preferably 300°C. The upper limit value and the lower limit value can be combined arbitrarily.

The solvent A includes organic solvents capable of dissolving or uniformly dispersing organic EL materials (the above-described polymer compounds, low molecular weight compounds and the like). Such an organic solvent can be selected from, for example, a hydrocarbon solvent, an alcohol solvent (mono-hydric alcohol solvent, poly-hydric alcohol solvent), an ester solvent, a ketone solvent, an ether solvent, a solvent containing a nitrogen atom, a solvent containing a sulfur atom, and the like. Of them, an aliphatic hydrocarbon solvent, an aromatic hydrocarbon solvent, a mono-hydric alcohol solvent, a poly-hydric alcohol solvent, an aromatic ester solvent, an aliphatic-aliphatic ether solvent, an aromatic-aromatic ether solvent, a solvent containing a sulfur atom, and the like are preferred.

The aliphatic hydrocarbon solvent having a boiling point of 250°C or higher includes, for example, n-tetradecane (boiling point: 253°C), and the aromatic hydrocarbon solvent having a boiling point of 250°C or higher includes, for example, n-octylbenzene (boiling point: 250°C), n-nonylbenzene (boiling point: 282°C), n-decylbenzene (boiling point: 298°C), n-undecylbenzene (boiling point: 316°C) and n-dodecylbenzene. Of them, aromatic hydrocarbon solvents are preferable, n-decylbenzene, n-undecylbenzene and n-dodecylbenzene are more preferable, and n-decylbenzene and n-dodecylbenzene are further preferable.

The mono-hydric alcohol solvent having a boiling point of 250°C or higher includes, for example, 1-dodecanol (boiling point: 259°C), and the poly-hydric alcohol solvent having a boiling point of 250°C or higher includes, for example, glycerin (boiling point: 290°C) and 1,6-hexanediol (boiling point: 250°C). Of them, poly-hydric alcohol solvents are preferred.

The aromatic ester solvent having a boiling point of 250°C or higher includes, for example, n-butyl benzoate (boiling point: 250°C), tert-butyl benzoate, n-pentyl benzoate, n-hexyl benzoate (boiling point: 272°C), dimethyl phthalate

(boiling point: 282°C) and diethyl phthalate (boiling point: 302°C). Of them, n-pentyl benzoate, n-hexyl benzoate and dimethyl phthalate are preferable, and n-hexyl benzoate is more preferable.

The aliphatic-aliphatic ether solvent having a boiling point of 250°C or higher includes, for example, tetraethylene glycol dimethyl ether (boiling point: 276°C), and the aromatic-aromatic ether solvent having a boiling point of 250°C or higher includes 3-phenoxytoluene (boiling point: 272°C). Of them, aromatic-aromatic ether solvents are preferred.

The solvent containing a sulfur atom having a boiling point of 250°C or higher includes, for example, sulfolane (boiling point: 285°C).

In the organic EL device, the solvent A having a boiling point of 250°C or higher may be contained singly or in combination of two or more.

<Head space gas chromatography method>

The solvent A contained in the above-described organic EL device can be measured by, for example, a head space gas chromatography method. Similar to the gas chromatography method, the intended organic solvent can be quantified from the previously obtained calibration curve and AREA area. Specific measurement methods and quantification means are as described below.

The front surface, back surface and side surface of the organic EL element to be measured are lightly wiped with a cloth containing a solvent such as acetone to remove impurities adhered. Next, the volume of the organic EL material in the organic EL element is measured by the method described later. Next, the organic EL element is pulverized with a mill or the like, and a predetermined amount thereof is sealed in a vial for head space to prepare a measurement sample. Using a gas chromatography mass spectrometer equipped with a head space autosampler, the m/z of the peak of the solvent contained is specified by the scan measurement, and the solvent type is specified. Using a standard product of the specified solvent type, a calibration curve consisting of the content and the AREA area value measured by gas chromatography is prepared. The vicinity of the specified m/z is measured in detail, and the AREA area value of the solvent type contained in the measurement sample is measured, and the content is calculated from the above calibration curve.

<Evaluation of volume of organic EL material (area and thickness evaluation means)>

The volume of the organic EL material in the organic EL element can be calculated from, for example, the light emitting area and the thickness. The above-described light emitting area can be confirmed electrically, or can be confirmed with a polarizing microscope or the like. The thickness can be confirmed with an LCR meter, a step meter, or the like, or can be confirmed by cross-sectional observation using an electron microscope or the like.

<Polymer compound>

When the organic EL material contains a polymer compound, the polymer compound includes, for example, polymer compounds containing a constitutional unit represented by the formula (Y).

$$-[-Ar^{Y1}]- \qquad (Y)$$

[wherein, $Ar^{Y1}$ represents an arylene group, a divalent heterocyclic group, or a divalent group in which at least one arylene group and at least one divalent heterocyclic group are bonded directly, and the foregoing groups optionally have a substituent.]

The arylene group represented by $Ar^{Y1}$ is preferably a phenylene group, a phenanthrenediyl group, a dihydrophenanthrenediyl group or a fluorenediyl group, more preferably a phenylene group or a fluorenediyl group, and the foregoing groups optionally have a substituent.

The divalent heterocyclic group represented by $Ar^{Y1}$ is preferably a divalent group obtained by removing from pyridine, diazabenzene, triazine, carbazole, dibenzofuran, dibenzothiophene, phenoxazine or phenothiazine two hydrogen atoms among hydrogen atoms bonding directly to carbon atoms or hetero atoms constituting the ring, more preferably a divalent group obtained by removing from pyridine, diazabenzene or triazine two hydrogen atoms among hydrogen atoms bonding directly to carbon atoms or hetero atoms constituting the ring, and the foregoing groups optionally have a substituent.

The preferable range and more preferable range of the arylene group and the divalent heterocyclic group in the divalent group in which at least one arylene group and at least one divalent heterocyclic group are bonded directly represented by $Ar^{Y1}$ are the same as the preferable range and more preferable range of the arylene group and the divalent heterocyclic group represented by $Ar^{Y1}$ described above, respectively. The divalent group in which at least one arylene group and at least one divalent heterocyclic group are bonded directly optionally has a substituent.

The "divalent group in which at least one arylene group and at least one divalent heterocyclic group are bonded directly" includes, for example, groups represented by the following formulae. These optionally have a substituent.

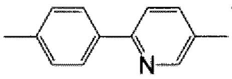
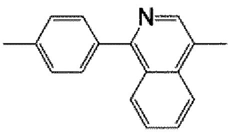
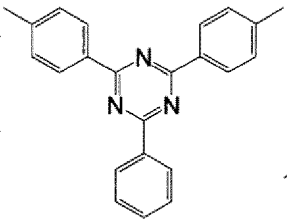
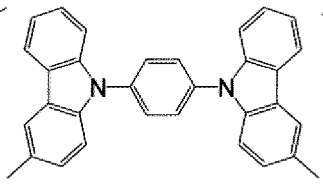
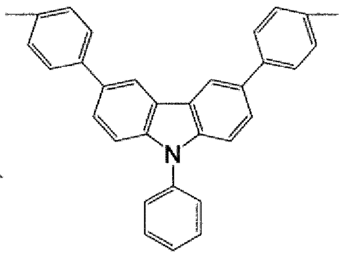

The substituent which a group represented by $Ar^{Y1}$ optionally has is preferably an alkyl group, a cycloalkyl group or an aryl group, and the foregoing groups optionally further have a substituent.

The substituent which a substituent which a group represented by $Ar^{Y1}$ optionally has optionally further has is preferably an alkyl group or a cycloalkyl group, and the foregoing groups optionally further have a substituent, but it is preferable that they do not further have a substituent.

The constitutional unit represented by the formula (Y) includes, for example, constitutional units represented by the formulae (Y-1) to (Y-10) shown below. From the stand point of the luminance life of the organic EL device according to the present invention, constitutional units represented by the formulae (Y-1) to (Y-3) are preferred, from the standpoint of the electron transportability thereof, constitutional units represented by the formulae (Y-4) to (Y-7) are preferred, and, from the standpoint of the hole transportability thereof, constitutional units represented by the formulae (Y-8) to (Y-10) are preferred.

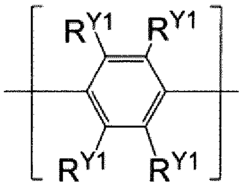
(Y-1)

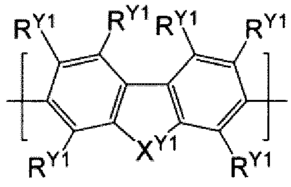
(Y-2)

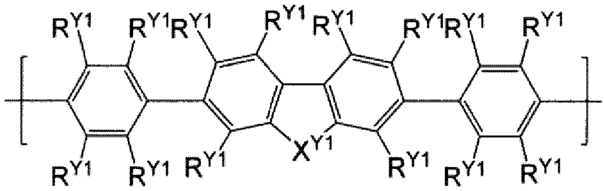
(Y-3)

[wherein,

$R^{Y1}$ represents a hydrogen atom, an alkyl group, a cycloalkyl group, an alkoxy group, a cycloalkoxy group, an aryl group or a monovalent heterocyclic group, and the foregoing groups optionally have a substituent. The plurality of $R^{Y1}$ may be the same or different, and the adjacent groups $R^{Y1}$ may be combined together to form a ring together with carbon atoms to which they are attached.

$X^{Y1}$ represents a group represented by $-C(R^{Y2})_2-$, $-C(R^{Y2})=C(R^{Y2})-$ or $C(R^{Y2})_2-C(R^{Y2})_2-$. $R^{Y2}$ represents a hydrogen atom, an alkyl group, a cycloalkyl group, an alkoxy group, a cycloalkoxy group, an aryl group or a monovalent heterocyclic group, and the foregoing groups optionally have a substituent. The plurality of $R^{Y2}$ may be the same or different, and the groups $R^{Y2}$ may be combined together to form a ring together with carbon atoms to which they are attached.]

$R^{Y1}$ is preferably a hydrogen atom, an alkyl group, a cycloalkyl group or an aryl group, and the foregoing groups optionally have a substituent.

$R^{Y2}$ is preferably an alkyl group, a cycloalkyl group, an aryl group or a monovalent heterocyclic group, more preferably an alkyl group, a cycloalkyl group or an aryl group, and the foregoing groups optionally have a substituent.

Regarding the combination of two groups $R^{Y2}$ in a group represented by $-C(R^{Y2})_2-$ for $X^{Y1}$, it is preferable that both are alkyl groups or cycloalkyl groups, both are aryl groups, both are monovalent heterocyclic groups, or one is an alkyl group or a cycloalkyl group and the other is an aryl group or a monovalent heterocyclic group, it is more preferable that one is an alkyl group or a cycloalkyl group and the other is an aryl group, and the foregoing groups optionally have a substituent. The two groups $R^{Y2}$ may be combined together to form a ring together with atoms to which they are attached, and when $R^{Y2}$ forms a ring, the group represented by $-C(R^{Y2})_2-$ is preferably a group represented by the formulae (Y-A1) to (Y-A5), more preferably a group represented by the formula (Y-A4), and the foregoing groups optionally have a substituent.

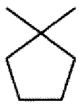
(Y-A1)
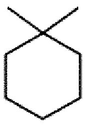
(Y-A2)
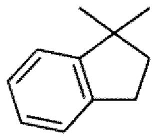
(Y-A3)
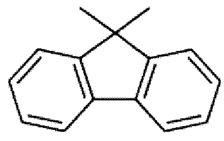
(Y-A4)
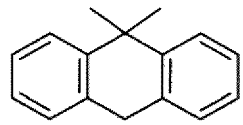
(Y-A5)

Regarding the combination of two groups $R^{Y2}$ in a group represented by $-C(R^{Y2})=C(R^{Y2})-$ for $X^{Y1}$, it is preferable that both are alkyl groups or cycloalkyl groups, or one is an alkyl group or a cycloalkyl group and the other is an aryl group, and the foregoing groups optionally have a substituent.

Four groups $R^{Y2}$ in a group represented by $-C(R^{Y2})_2-C(R^{Y2})_2-$ for $X^{Y1}$ are preferably alkyl groups or cycloalkyl groups optionally having a substituent. The plurality of $R^{Y2}$ may be combined together to form a ring together with atoms to which they are attached, and when $R^{Y2}$ forms a ring, the group represented by $-C(R^{Y2})_2-C(R^{Y2})_2-$ is preferably a group represented by the formulae (Y-B1) to (Y-B5), more preferably a group represented by the formula (Y-B3), and the foregoing groups optionally have a substituent.

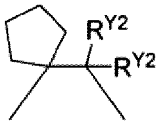
(Y-B1)
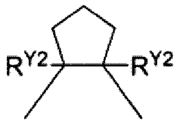
(Y-B2)
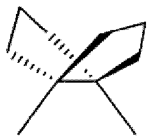
(Y-B3)
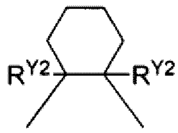
(Y-B4)
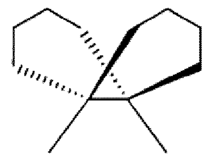
(Y-B5)

[wherein, $R^{Y2}$ represents the same meaning as described above.]

$X^{Y1}$ is preferably a group represented by $-C(R^{Y2})_2-$.

The constitutional unit represented by the formula (Y-1) is preferably a constitutional unit represented by the formula (Y-1') described below. The constitutional unit represented by the formula (Y-2) is preferably a constitutional unit represented by the formula (Y-2') described below. The constitutional unit represented by the formula (Y-3) is preferably a constitutional unit represented by the formula (Y-3') described below.

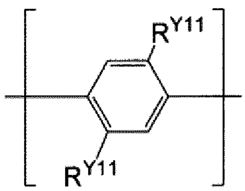
**(Y-1')**
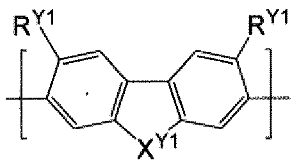
**(Y-2')**
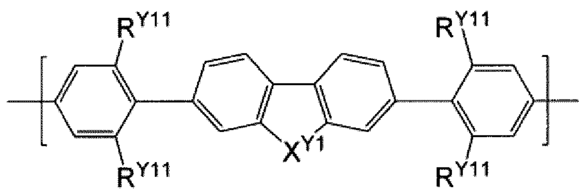
**(Y-3')**

[wherein, $R^{Y1}$ and $X^{Y1}$ represent the same meaning as described above.

$R^{Y11}$ represents a fluorine atom, an alkyl group, a cycloalkyl group, an aryl group, a monovalent heterocyclic group, an alkoxy group, a cycloalkoxy group or a substituted amino group, and the foregoing groups optionally have a substituent. The plurality of $R^{Y11}$ may be the same or different.]

$R^{Y11}$ is preferably an alkyl group, a cycloalkyl group, an aryl group or a monovalent heterocyclic group, more preferably an alkyl group, a cycloalkyl group or an aryl group, further preferably an alkyl group or a cycloalkyl group, and the foregoing groups optionally have a substituent.

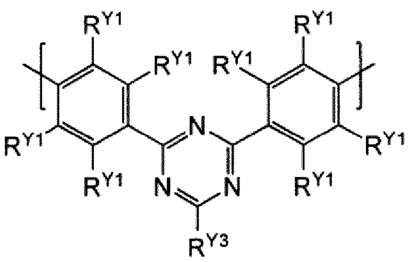

(Y-4)

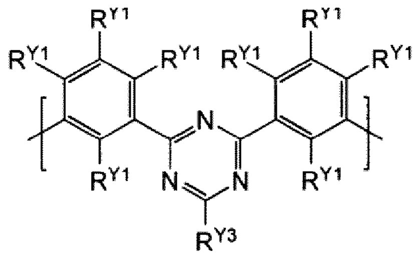

(Y-5)

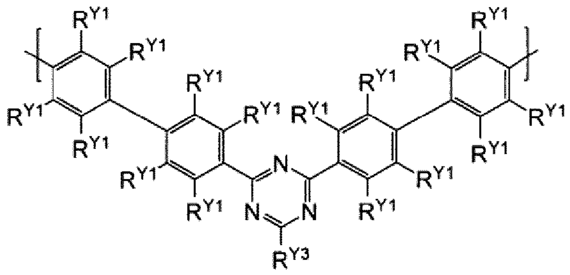

(Y-6)

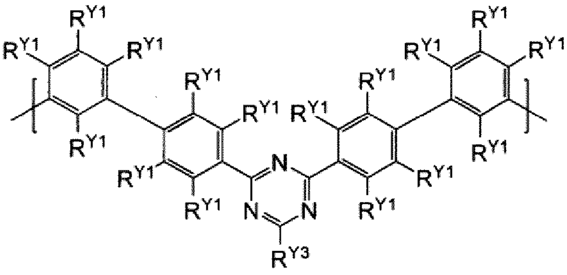

(Y-7)

[wherein,
$R^{Y1}$ represents the same meaning as described above.

$R^{Y3}$ represents a hydrogen atom, an alkyl group, a cycloalkyl group, an alkoxy group, a cycloalkoxy group, an aryl group or a monovalent heterocyclic group, and the foregoing groups optionally have a substituent.]

$R^{Y3}$ is preferably an alkyl group, a cycloalkyl group, an alkoxy group, a cycloalkoxy group, an aryl group or a monovalent heterocyclic group, more preferably an aryl group, and the foregoing groups optionally have a substituent.

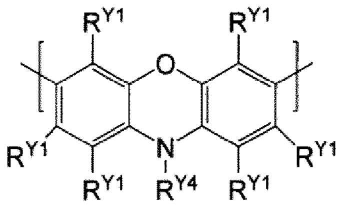

(Y-8)

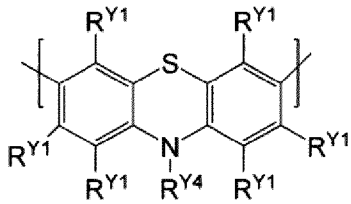

(Y-9)

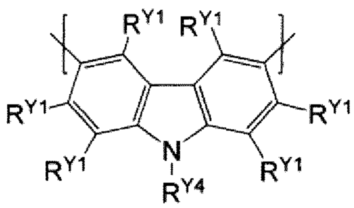

(Y-10)

[wherein,
$R^{Y1}$ represents the same meaning as described above.

$R^{Y4}$ represents a hydrogen atom, an alkyl group, a cycloalkyl group, an alkoxy group, a cycloalkoxy group, an aryl group or a monovalent heterocyclic group, and the foregoing groups optionally have a substituent.]

$R^{Y4}$ is preferably an alkyl group, a cycloalkyl group, an aryl group or a monovalent heterocyclic group, more preferably an aryl group, and the foregoing groups optionally have a substituent.

The preferable range of the substituent which a group represented by $R^{Y1}$ to $R^{Y4}$ and $R^{Y11}$ optionally has is the same as the preferable range of the substituent which a group represented by $Ar^{Y1}$ optionally has.

The constitutional unit represented by the formula (Y) includes, for example, constitutional units composed of an arylene group represented by the formulae (Y-101) to (Y-120), constitutional units composed of a divalent heterocyclic group represented by the formulae (Y-201) to (Y-206), and constitutional units composed of a divalent group in which at least one arylene group and at least one divalent heterocyclic group are bonded directly represented by the formulae (Y-301) to (Y-304).

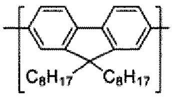
(Y-101)

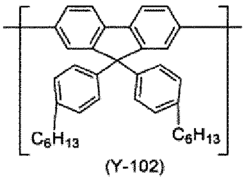
(Y-102)

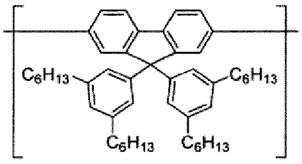
(Y-103)

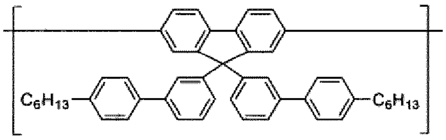
(Y-104)

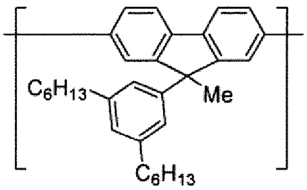
(Y-105)

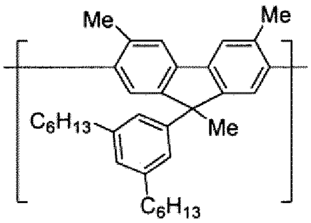
(Y-106)

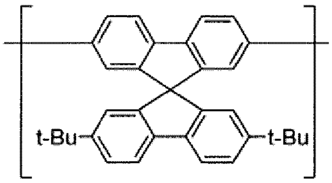
(Y-107)

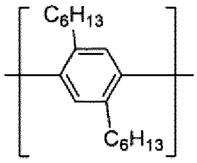
(Y-109)

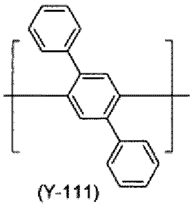
(Y-111)

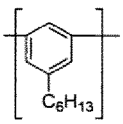
(Y-113)

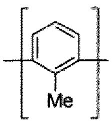
(Y-114)

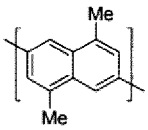
(Y-115)

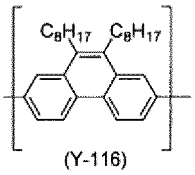
(Y-116)

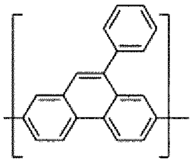
(Y-117)

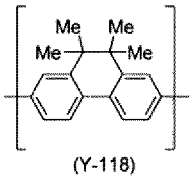
(Y-118)

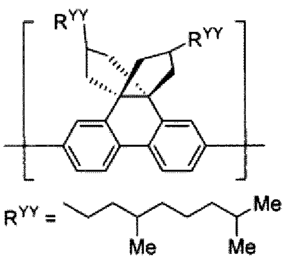
(Y-119)

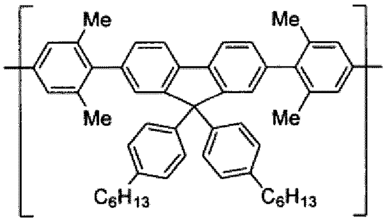
(Y-120)

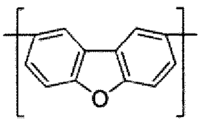
(Y-201)

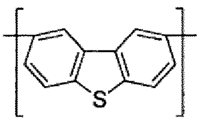
(Y-202)

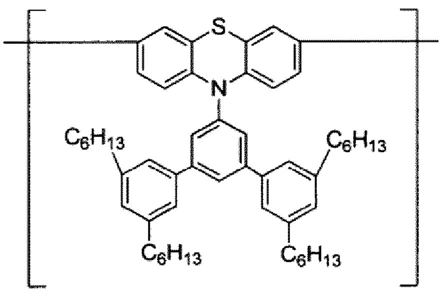
(Y-203)

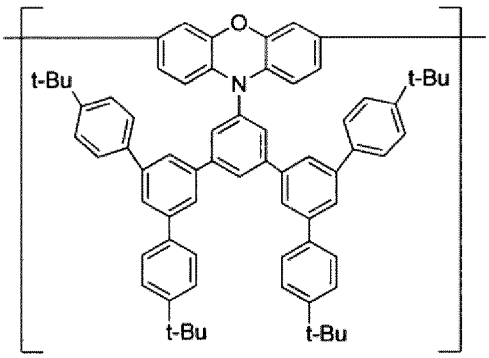
(Y-204)

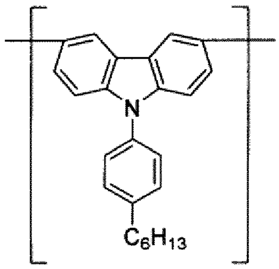

(Y-205)

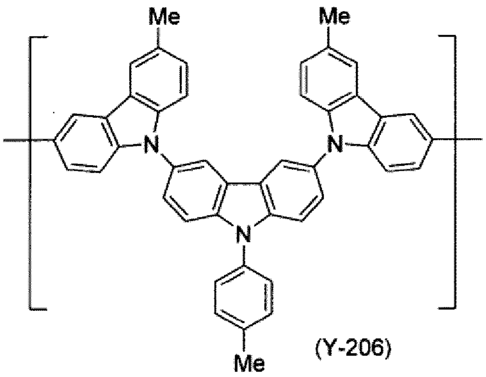

(Y-206)

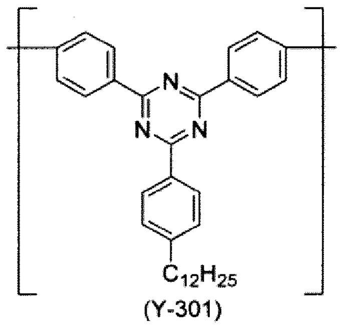

(Y-301)

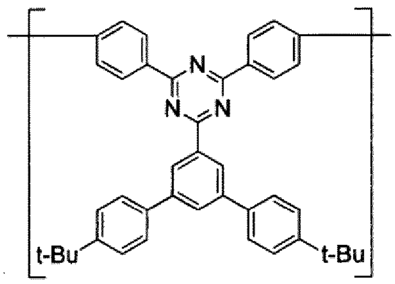

(Y-302)

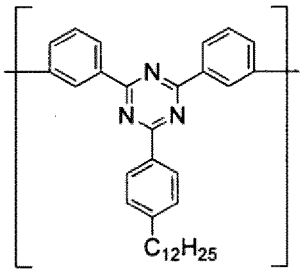

(Y-303)

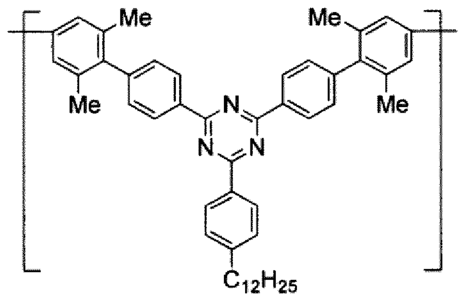

(Y-304)

The amount of a constitutional unit represented by the formula (Y) in which $Ar^{Y1}$ is an arylene group is preferably 0.1 to 100% by mole, more preferably 1 to 99% by mole, further preferably 30 to 95% by mole, particularly preferably 50 to 90% by mole, may be 0.5 to 80% by mole, and may also be 30 to 60% by mole, with respect to the total amount of constitutional units contained in the polymer compound.

The amount of a constitutional unit represented by the formula (Y) in which $Ar^{Y1}$ is a divalent heterocyclic group, or a divalent group in which at least one arylene group and at least one divalent heterocyclic group are bonded directly is preferably 0.5 to 30% by mole, and more preferably 3 to 20% by mole, with respect to the total amount of constitutional units contained in the polymer compound.

The constitutional unit represented by the formula (Y) may be contained only singly or in combination of two or more in the polymer compound.

It is preferable that the polymer compound containing a constitutional unit represented by the formula (Y) further contains a constitutional unit represented by the following formulae (X), since excellent hole transportability is obtained.

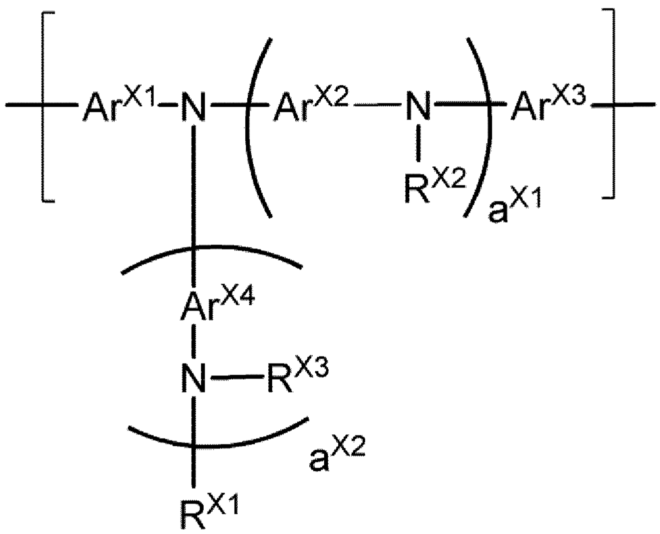

(X)

[wherein,

$a^{X1}$ and $a^{X2}$ each independently represent an integer of 0 or more.

$Ar^{X1}$ and $Ar^{X3}$ each independently represent an arylene group or a divalent heterocyclic group, and the foregoing groups optionally have a substituent.

$Ar^{X2}$ and $Ar^{X4}$ each independently represent an arylene group, a divalent heterocyclic group, or a divalent group in which at least one arylene group and at least one divalent heterocyclic group are bonded directly, and the foregoing groups optionally have a substituent. When a plurality of $Ar^{X2}$ and $Ar^{X4}$ are present, they may be the same or different at each occurrence.

$R^{X1}$, $R^{X2}$ and $R^{X3}$ each independently represent a hydrogen atom, an alkyl group, a cycloalkyl group, an aryl group or a monovalent heterocyclic group, and the foregoing groups optionally have a substituent. When a plurality of $R^{X2}$ and $R^{X3}$ are present, they may be the same or different at each occurrence.]

$a^{X1}$ is usually an integer of 0 to 5, preferably an integer of 0 to 2, and more preferably 0 or 1. $a^{X2}$ is usually an integer of 0 to 5, preferably an integer of 0 to 2, and more preferably 0.

The preferable range and more preferable range of $R^{X1}$, $R^{X2}$ and $R^{X3}$ are the same as the preferable range and more preferable range of $R^{Y4}$.

The preferable range and more preferable range of the arylene group and the divalent heterocyclic group represented by $Ar^{X1}$, $Ar^{X2}$, $Ar^{X3}$ and $Ar^{X4}$ are the same as the preferable range and more preferable range of the arylene group and the divalent heterocyclic group represented by $Ar^{Y1}$, respectively.

The examples and preferable range and the like of the divalent group in which at least one arylene group and at least one divalent heterocyclic group are bonded directly represented by $Ar^{X2}$ and $Ar^{X4}$ are the same as the examples and preferable range and the like of the divalent group in which at least one arylene group and at least one divalent heterocyclic group are bonded directly represented by $Ar^{Y1}$, respectively.

$Ar^{X1}$, $Ar^{X2}$, $Ar^{X3}$ and $Ar^{X4}$ are preferably arylene groups optionally having a substituent.

The preferable range of the substituent which a group represented by $Ar^{X1}$ to $Ar^{X4}$ and $R^{X1}$ to $R^{X3}$ optionally has is the same as the preferable range of the substituent which a group represented by $Ar^{Y1}$ optionally has.

The amount of the constitutional unit represented by the formula (X) is preferably 0.1 to 99% by mole, more preferably 1 to 50% by mole and further preferably 5 to 30% by mole, with respect to the total amount of constitutional units contained in the polymer compound.

The constitutional unit represented by the formula (Y) may be contained only singly or in combination of two or more in the polymer compound.

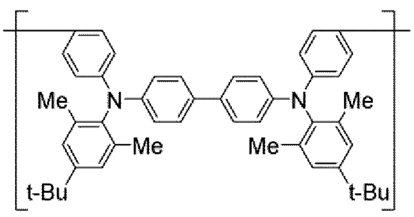
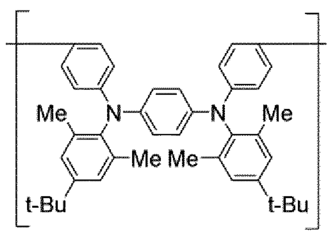
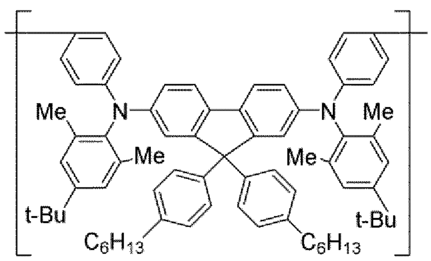
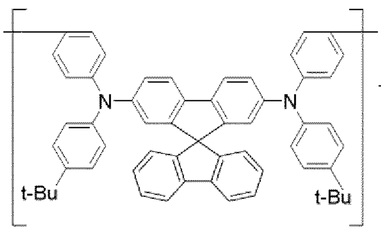
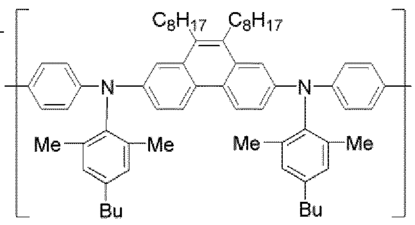
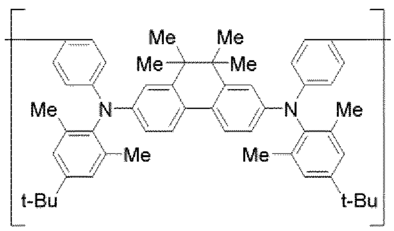
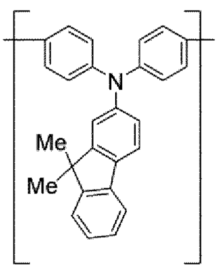
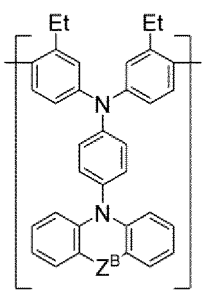
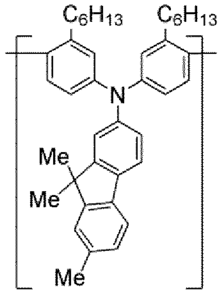
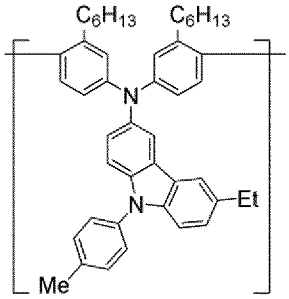
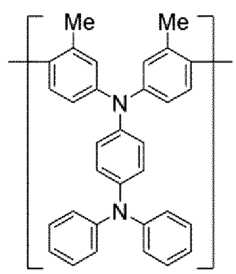

<Low molecular weight compound>

When the organic EL material contains a low molecular weight compound, the low molecular weight compound includes, for example, low molecular weight compounds represented by the formula (H-1).

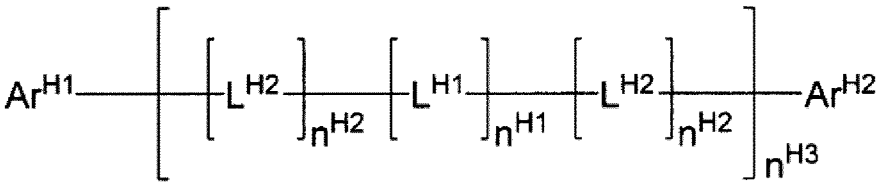

**(H-1)**

[wherein,
$Ar^{H1}$ and $Ar^{H2}$ each independently represent an aryl group or a monovalent heterocyclic group, and the foregoing groups optionally have a substituent.

$n^{H1}$ and $n^{H2}$ each independently represent 0 or 1. When a plurality of $n^{H1}$ are present, they may be the same or different. A plurality of $n^{H2}$ may be the same or different.

$n^{H3}$ represents an integer of 0 or more and 10 or less.

$L^{H1}$ represents an arylene group, a divalent heterocyclic group or a group represented by - [C ($R^{H11}$) $_2$]$n^{H11}$-, and the foregoing groups optionally have a substituent. When a plurality of $L^{H1}$ are present, they may be the same or different. $n^{H11}$ represents an integer of 1 or more and 10 or less. $R^{H11}$ represents a hydrogen atom, an alkyl group, a cycloalkyl group, an alkoxy group, a cycloalkoxy group, an aryl group or a monovalent heterocyclic group, and the foregoing groups optionally have a substituent. A plurality of $R^{H11}$ may be the same or different, and may be combined together to form a ring together with carbon atoms to which they are attached.

$L^{H2}$ represents a group represented by -N (-$L^{H21}$-$R^{H21}$) -. When a plurality of $L^{H2}$ are present, they may be the same or different. $L^{H21}$ represents a single bond, an arylene group or a divalent heterocyclic group, and the foregoing groups optionally have a substituent. $R^{H21}$ represents a hydrogen atom, an alkyl group, a cycloalkyl group, an aryl group or a monovalent heterocyclic group, and the foregoing groups optionally have a substituent.]

$Ar^{H1}$ and $Ar^{H2}$ are each preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a fluorenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a fluorenyl group, a spirobifluorenyl group, a dibenzothienyl group, a dibenzofuryl group or a carbazolyl group, particularly preferably a group represented by the formula (TDA-3) described later, and the foregoing groups optionally have a substituent.

The substituent which $Ar^{H1}$ and $Ar^{H2}$ optionally have is preferably a halogen atom, an alkyl group, a cycloalkyl group, an alkoxy group, a cycloalkoxy group, an aryl group or a monovalent heterocyclic group, more preferably an alkyl group, a cycloalkoxy group, an alkoxy group or a cycloalkoxy group, further preferably an alkyl group or a cycloalkoxy group, and the foregoing groups optionally further have a substituent.

The substituent which a substituent which $Ar^{H1}$ and $Ar^{H2}$ optionally have optionally further has is preferably an alkyl group, a cycloalkyl group, an aryl group or a monovalent heterocyclic group, more preferably an alkyl group or a cycloalkyl group, and the foregoing groups optionally further have a substituent, but it is preferable that they do not further have a substituent.

$n^{H1}$ is preferably 1. $n^{H2}$ is preferably 0.

$n^{H3}$ is preferably an integer of 0 or more and 5 or less, further preferably an integer of 1 or more and 3 or less and particularly preferably 1.

$n^{H11}$ is preferably an integer of 1 or more and 5 or less, more preferably an integer of 1 or more and 3 or less and further preferably 1.

$R^{H11}$ is preferably a hydrogen atom, an alkyl group, a cycloalkyl group, an aryl group or a monovalent heterocyclic group, more preferably a hydrogen atom, an alkyl group or a cycloalkyl group, further preferably a hydrogen atom or an alkyl group, and the foregoing groups optionally have a substituent, but it is preferable that they do not further have a substituent.

$L^{H1}$ is preferably an arylene group or a divalent heterocyclic group, and the foregoing groups optionally further have a substituent.

$L^{H1}$ includes, for example, groups represented by the formula (A-1) to the formula (A-20) and groups represented by the formula (AA-1) to the formula (AA-34), shown below, and the like. $L^{H1}$ is preferably a group represented by the

formula (A-1) to the formula (A-3), the formula (A-8) to the formula (A-10), the formula (AA-1) to the formula (AA-6), the formula (AA-10) to the formula (AA-21) or the formula (AA-24) to the formula (AA-34), more preferably a group represented by the formula (A-1), the formula (A-2), the formula (A-8), the formula (A-9), the formula (AA-1) to the formula (AA-4), the formula (AA-10) to the formula (AA-15), the formula (AA-33) or the formula (AA-34), further preferably a group represented by the formula (A-1), the formula (A-2), the formula (A-8), the formula (AA-2), the formula (AA-4), the formula (AA-10), the formula (AA-12), the formula (AA-14) or (AA-33), particularly preferably a group represented by the formula (A-8), the formula (AA-10), the formula (AA-12) or the formula (AA-14), especially preferably a group represented by the formula (AA-14).

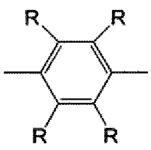
(A-1)

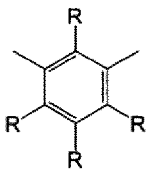
(A-2)

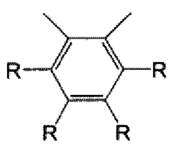
(A-3)

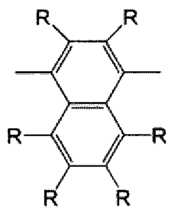
(A-4)

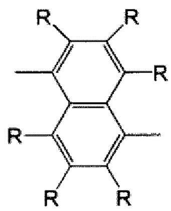
(A-5)

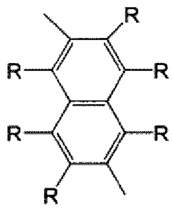
(A-6)

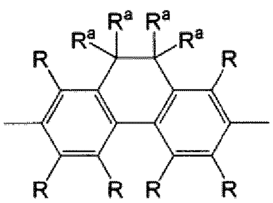
(A-7)

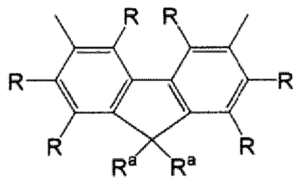
(A-8)

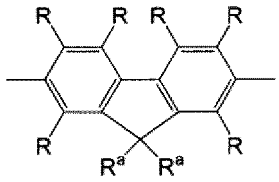
(A-9)

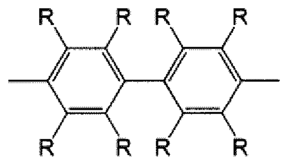
(A-10)

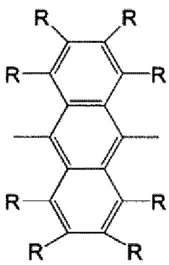
(A-11)

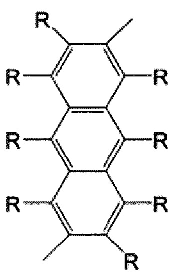
(A-12)

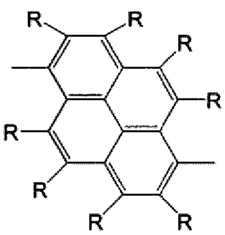
(A-13)

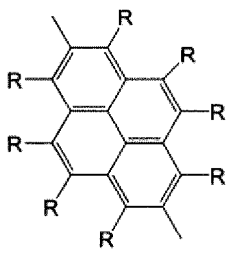
(A-14)

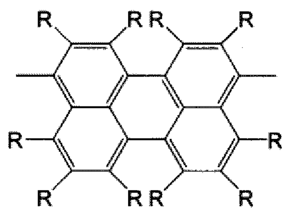
(A-15)

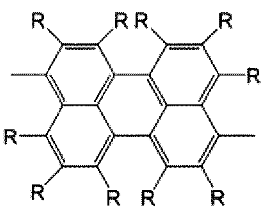
(A-16)

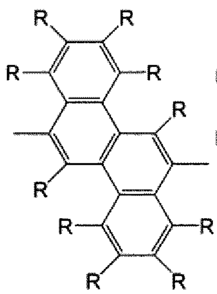
(A-17)

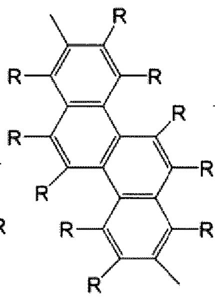
(A-18)

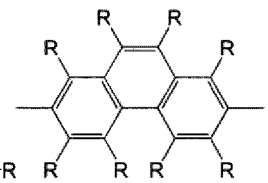
(A-19)

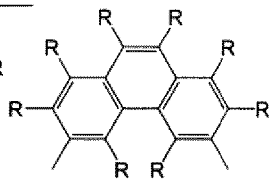
(A-20)

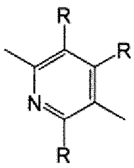
(AA-1)

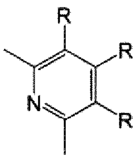
(AA-2)

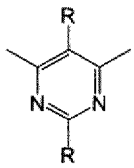
(AA-3)

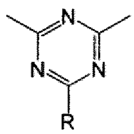
(AA-4)

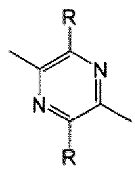
(AA-5)

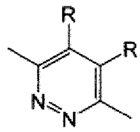
(AA-6)

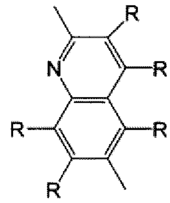
(AA-7)

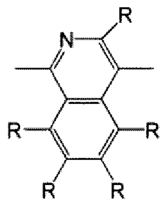
(AA-8)

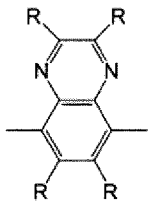
(AA-9)

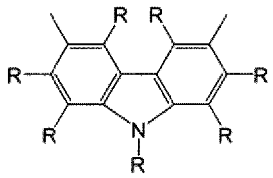
(AA-10)

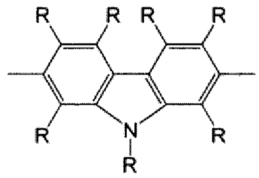
(AA-11)

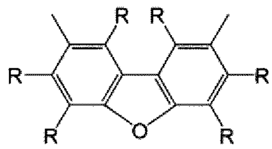
(AA-12)

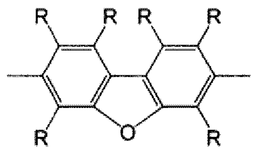
(AA-13)

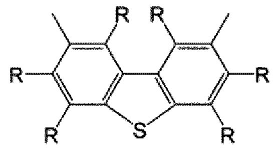
(AA-14)

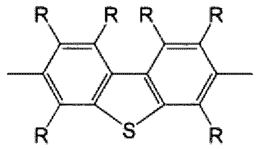
(AA-15)

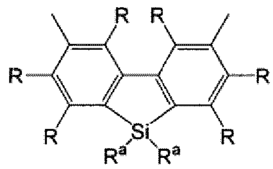
(AA-16)

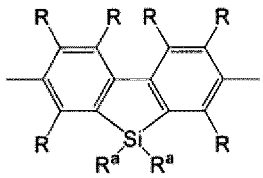
(AA-17)

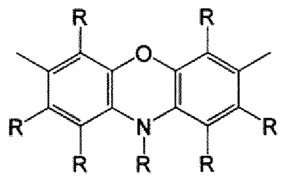
(AA-18)

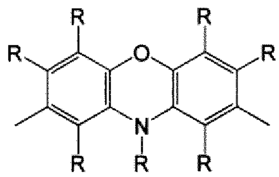
(AA-19)

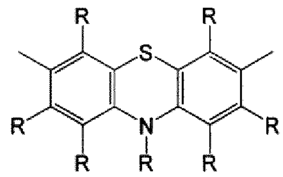
(AA-20)

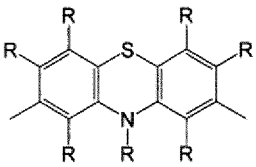
(AA-21)

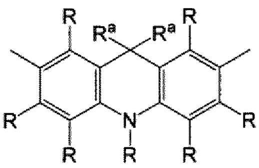
(AA-22)

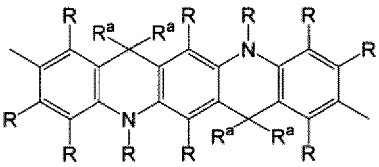
(AA-23)

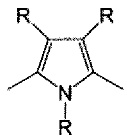
(AA-24)

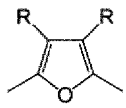
(AA-25)

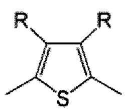
(AA-26)

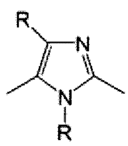
(AA-27)

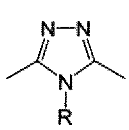
(AA-28)

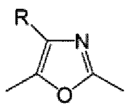
(AA-29)

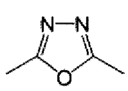
(AA-30)

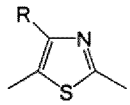
(AA-31)

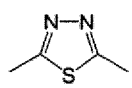
(AA-32)

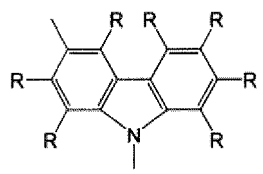
(AA-33)

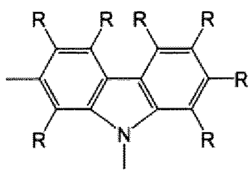
(AA-34)

[wherein, R and $R^a$ each independently represent a hydrogen atom, an alkyl group, a cycloalkyl group, an aryl group or a monovalent heterocyclic group. The plurality of R and $R^a$ each may be the same or different, and the plurality of $R^a$ may be combined together to form a ring together with atoms to which they are attached.]

The substituent which $L^{H1}$ optionally has is preferably a halogen atom, an alkyl group, a cycloalkyl group, an alkoxy group, a cycloalkoxy group, an aryl group or a monovalent heterocyclic group, more preferably an alkyl group, an alkoxy group, an aryl group or a monovalent heterocyclic group, further preferably an alkyl group, an aryl group or a monovalent heterocyclic group, particularly preferably a monovalent heterocyclic group, and the foregoing groups optionally further have a substituent.

The substituent which a substituent which $L^{H1}$ optionally has optionally further has is preferably an alkyl group, a cycloalkyl group, an aryl group or a monovalent heterocyclic group, more preferably an alkyl group or a cycloalkyl group, and the foregoing groups optionally further have a substituent, but it is preferable that they do not further have a substituent.

$L^{H21}$ is preferably a single bond or arylene group, more preferably a single bond, and the arylene group optionally has a substituent.

The definition and examples of the arylene group or the divalent heterocyclic group represented by $L^{H21}$ are the same as the definition and examples of the arylene group or the divalent heterocyclic group represented by $L^{H1}$.

The definition and examples of the substituent which $L^{H21}$ optionally has are the same as the definition and examples of the substituent which $L^{H1}$ optionally has.

$R^{H21}$ is preferably an aryl group or a monovalent heterocyclic group, and the foregoing groups optionally have a substituent.

The definition and examples of the aryl group and the monovalent heterocyclic group represented by $R^{H21}$ are the same as the definition and examples of the aryl group and the monovalent heterocyclic group represented by $Ar^{H1}$ and $Ar^{H2}$.

The definition and examples of the substituent which $R^{H21}$ optionally has are the same as the definition and examples of the substituent which $Ar^{H1}$ and $Ar^{H2}$ optionally have.

The compound represented by the formula (H-1) is preferably a compound represented by the formula (H-2).

$$Ar^{H1} - \left[ L^{H1} \right]_{n^{H3}} - Ar^{H2} \qquad \textbf{(H-2)}$$

[wherein, $Ar^{H1}$, $Ar^{H2}$, $n^{H3}$ and $L^{H1}$ represent the same meaning as described above.]

The compound represented by the formula (H-1) includes, for example, compounds represented by the following formulae. In the formulae, Z represents a group represented by -N= or a group represented by -CH=.

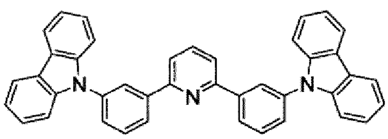
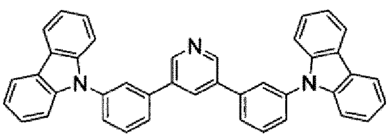
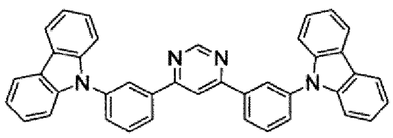

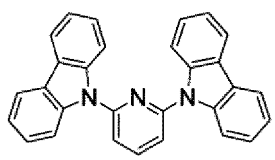
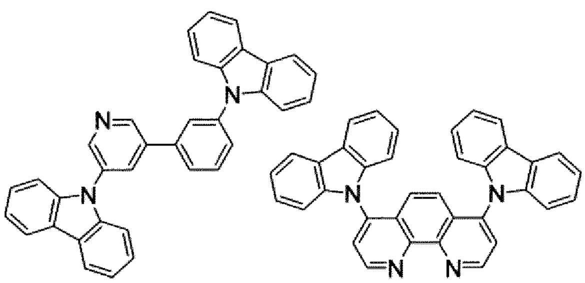
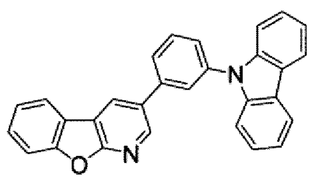

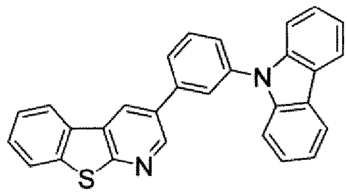

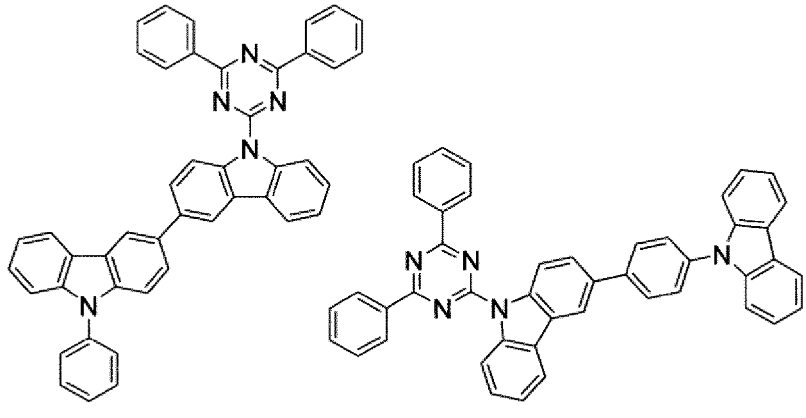

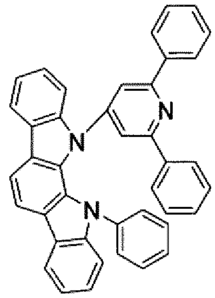

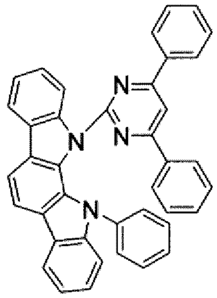

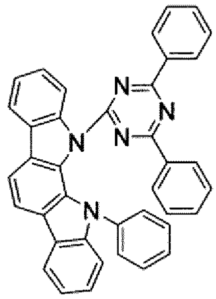

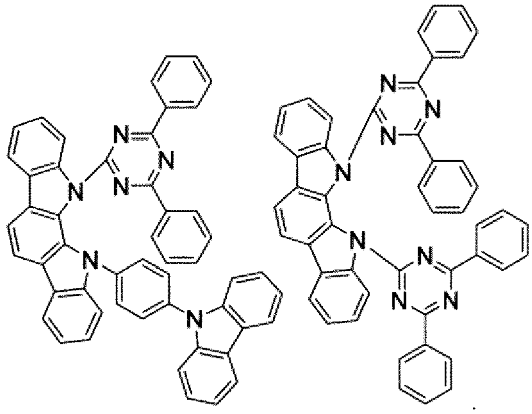

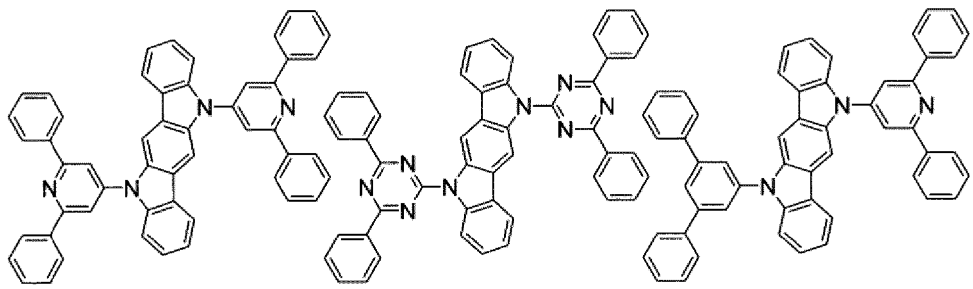

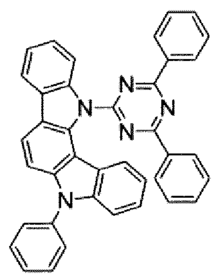

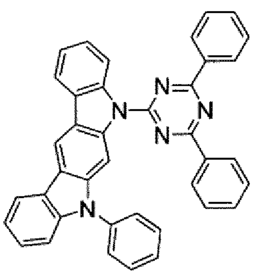

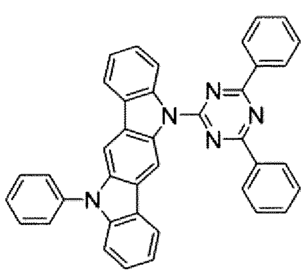

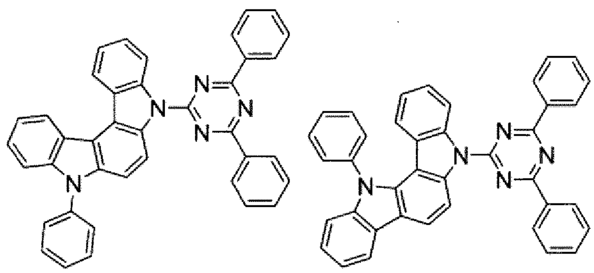

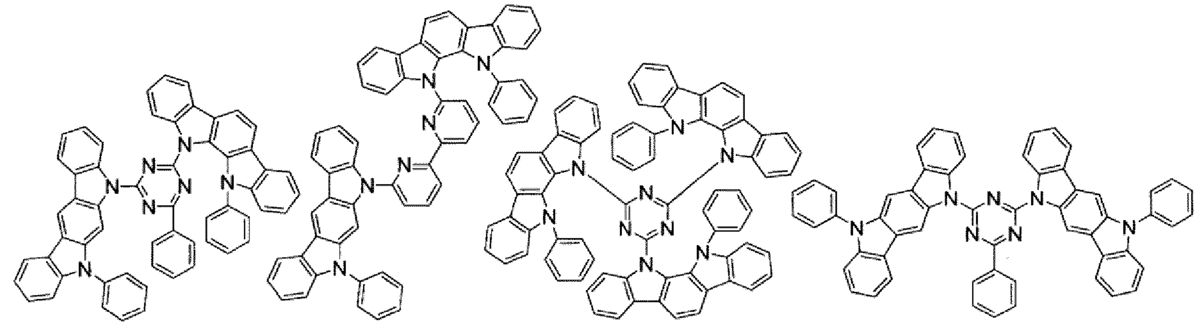

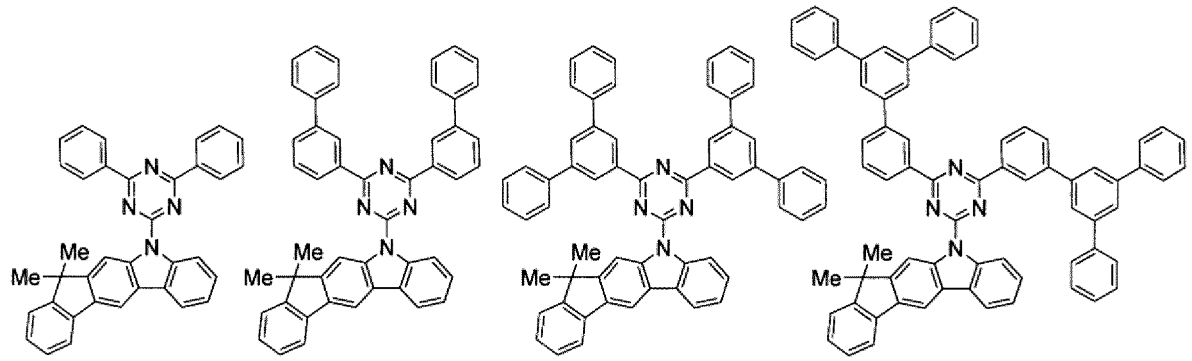

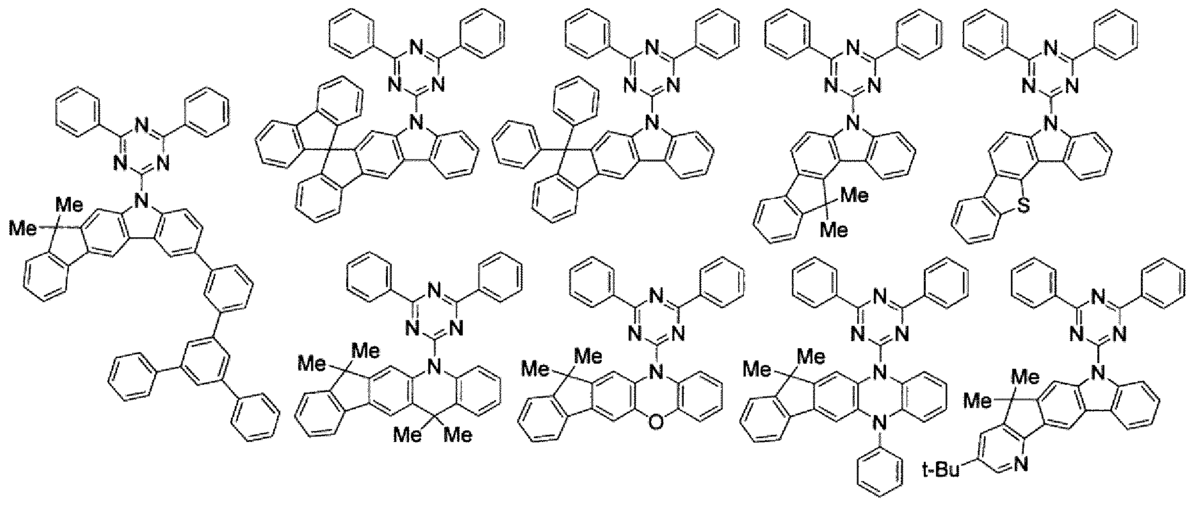

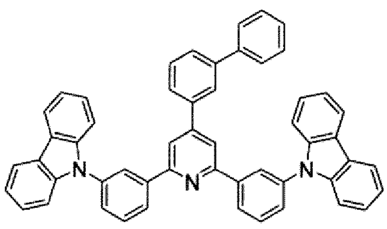

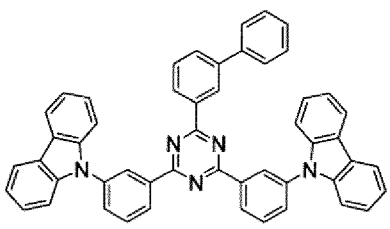

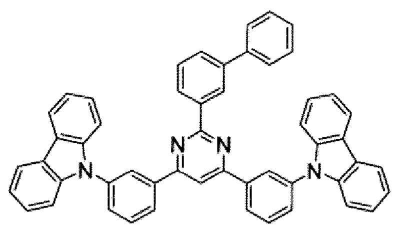

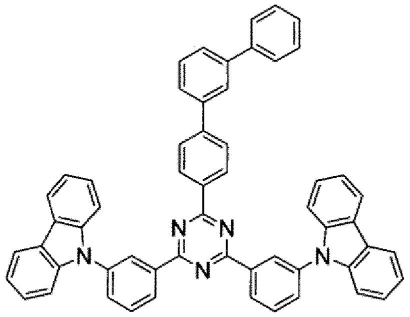

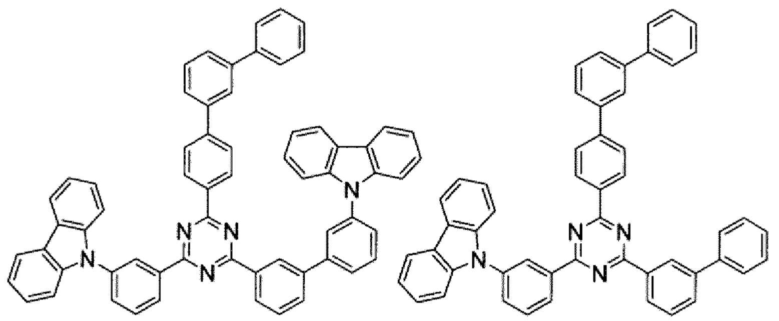

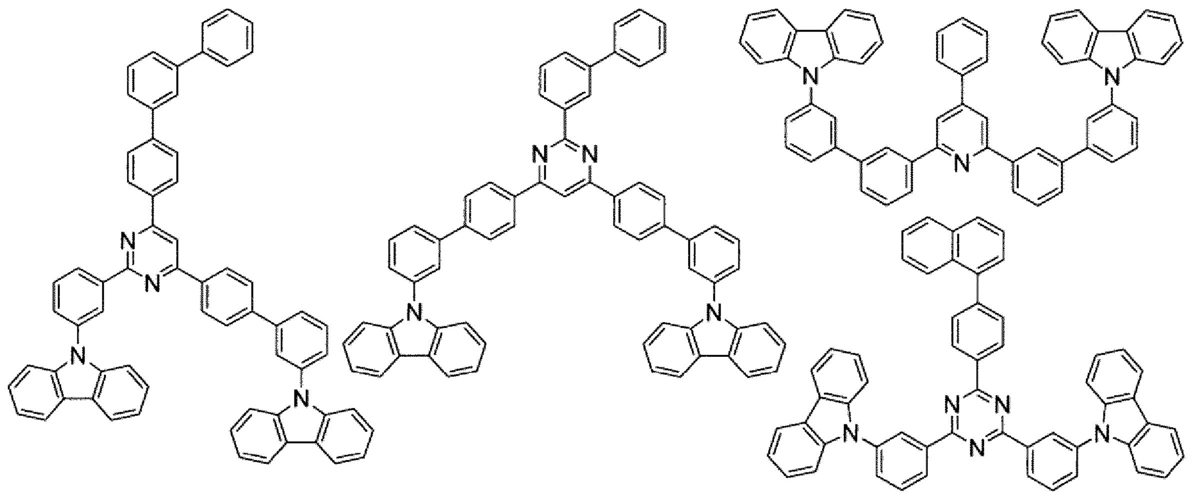

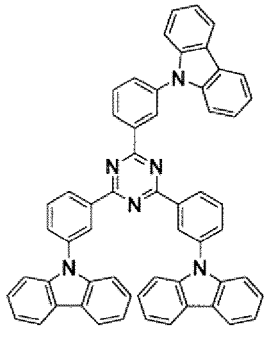

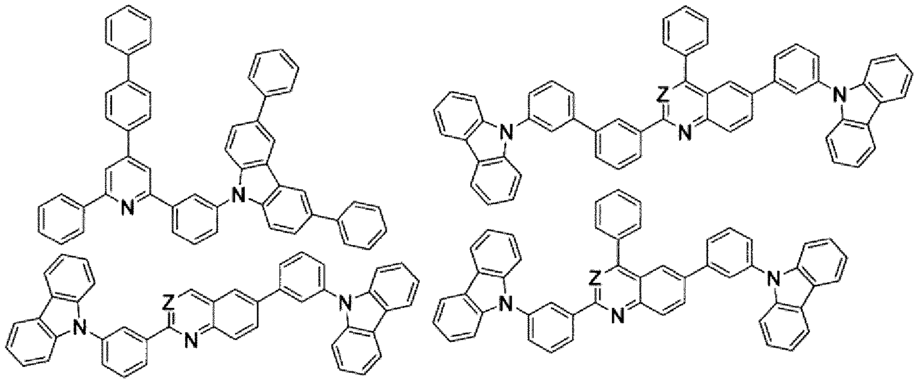

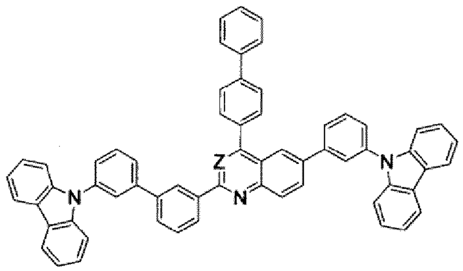

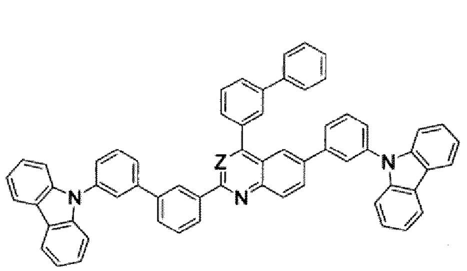

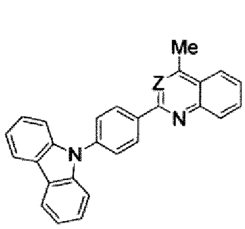

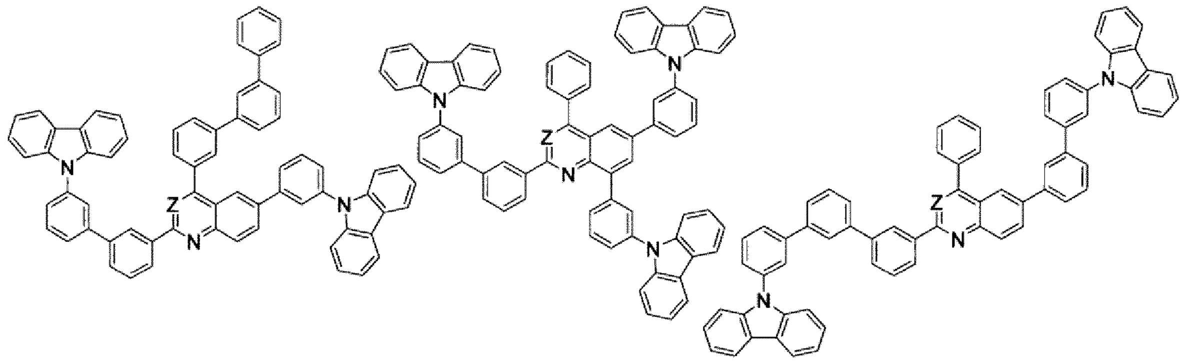

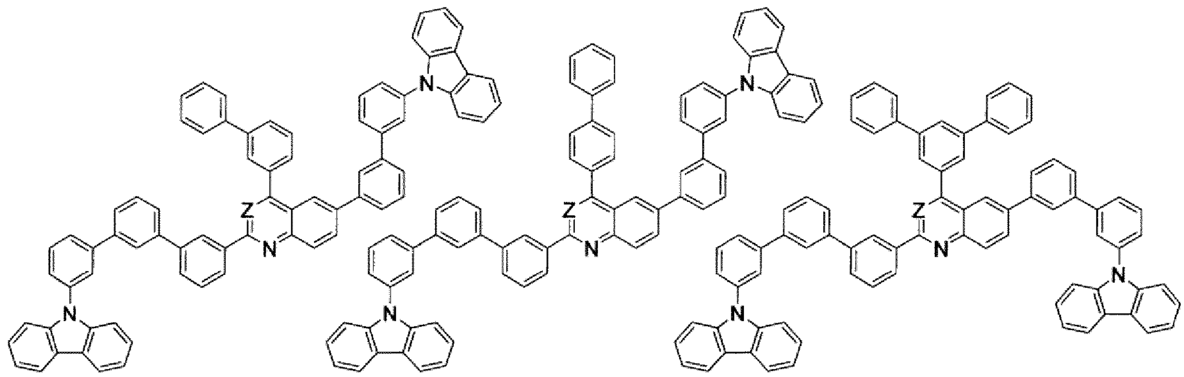

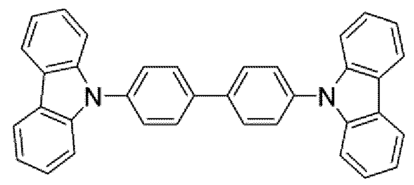
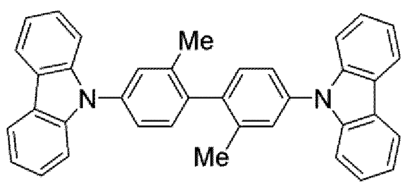
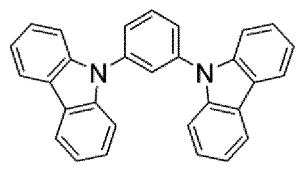

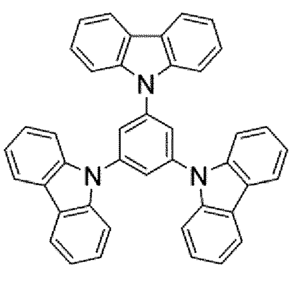
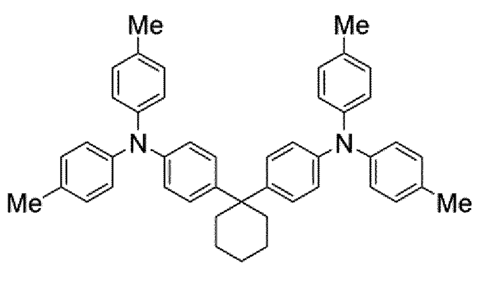
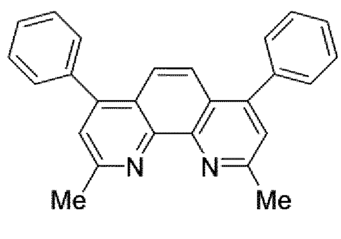

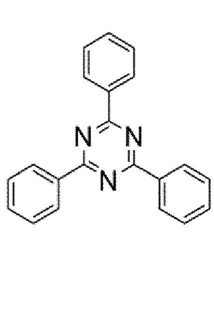
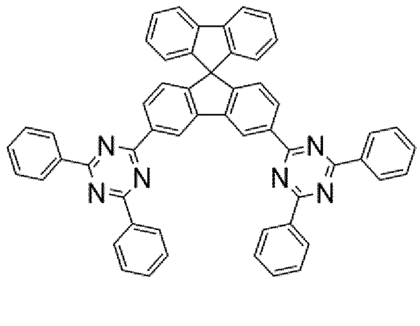
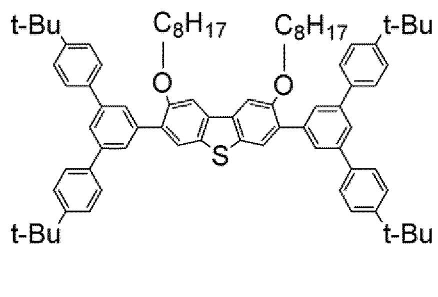

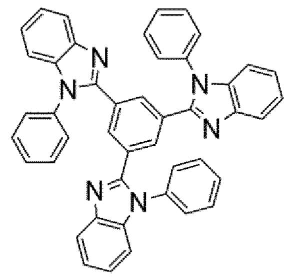

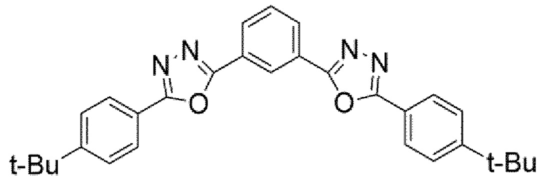

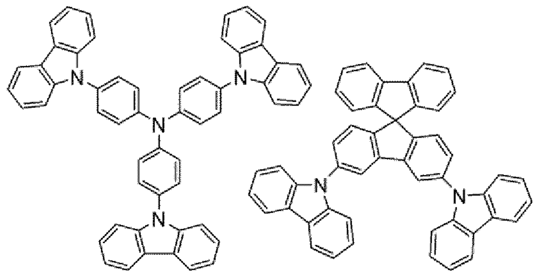

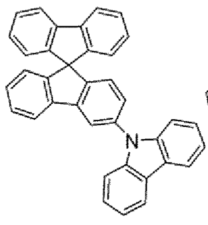

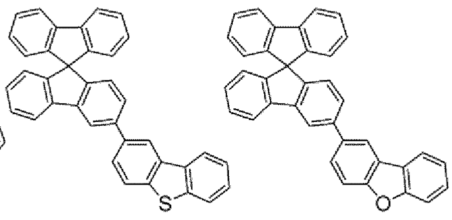

The compound represented by the formula (H-1) is available from Aldrich, Luminescence Technology Corp., and the like. Additionally, the compound can be synthesized according to a method described in, for example, International Publication WO2007/063754, International Publication WO2008/056746, International Publication WO2011/032686, International Publication WO2012/096263, JP-A No. 2009-227663 and JP-A No. 2010-275255.

The low molecular weight compound includes guest materials, that is, naphthalene and derivatives thereof, anthracene and derivatives thereof, perylene and derivatives thereof, and triplet light emitting complexes (phosphorescent compounds) containing iridium, platinum or europium as the central metal.

As the triplet light emitting complex, iridium complexes such as metal complexes represented by the formulae Ir-1 to Ir-5 and the like are preferable.

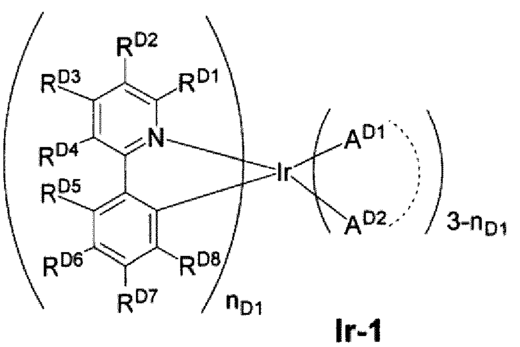

Ir-1

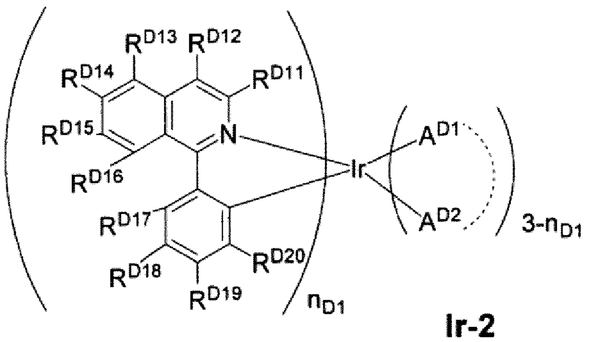

Ir-2

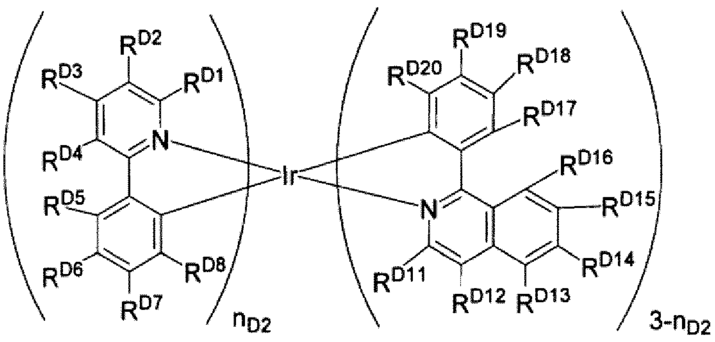

Ir-3

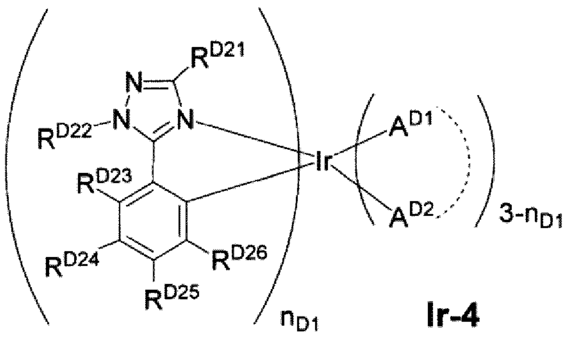
Ir-4

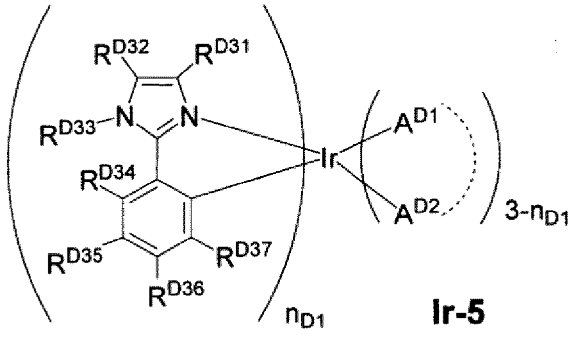
Ir-5

[wherein,

$R^{D1}$ to $R^{D8}$, $R^{D11}$ to $R^{D20}$, $R^{D21}$ to $R^{D26}$ and $R^{D31}$ to $R^{D37}$ each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom, and the foregoing groups optionally have a substituent. When a plurality of $R^{D1}$ to $R^{D8}$, $R^{D11}$ to $R^{D20}$, $R^{D21}$ to $R^{D26}$ and $R^{D31}$ to $R^{D37}$ are present, they may be the same or different at each occurrence.

$-A^{D1}$---$A^{D2}-$ represents an anionic bidentate ligand, $A^{D1}$ and $A^{D2}$ each independently represent a carbon atom, an oxygen atom or a nitrogen atom bonding to an iridium atom, and these atoms may be ring constituent atoms. When a plurality of $-A^{D1}$---$A^{D2}-$ are present, they may be the same or different.

$n_{D1}$ represents 1, 2 or 3, and $n_{D2}$ represents 1 or 2.]

$R^{D1}$ to $R^{D8}$, $R^{D11}$ to $R^{D20}$, $R^{D21}$ to $R^{D26}$ and $R^{D31}$ to $R^{D37}$ are each preferably a hydrogen atom, an alkyl group, a cycloalkyl group, an alkoxy group, a cycloalkoxy group, an aryl group, an aryloxy group, a monovalent heterocyclic group or a halogen atom, more preferably a hydrogen atom, an alkyl group, a cycloalkyl group, an aryl group or a monovalent heterocyclic group, further preferably a hydrogen atom, an aryl group or a monovalent heterocyclic group, particularly preferably a hydrogen atom or an aryl group, and the foregoing groups optionally have a substituent.

The substituent which $R^{D1}$ to $R^{D8}$, $R^{D11}$ to $R^{D20}$, $R^{D21}$ to $R^{D26}$ and $R^{D31}$ to $R^{D37}$ optionally have is preferably an alkyl group, a cycloalkyl group, an alkoxy group, a cycloalkoxy group, an aryl group, an aryloxy group, a monovalent heterocyclic group, a substituted amino group or a halogen atom, more preferably an alkyl group, a cycloalkyl group, an aryl group or a monovalent heterocyclic group, further preferably an alkyl group, a cycloalkyl group or an aryl group, and the foregoing groups optionally further have a substituent.

The substituent which a substituent which $R^{D1}$ to $R^{D8}$, $R^{D11}$ to $R^{D20}$, $R^{D21}$ to $R^{D26}$ and $R^{D31}$ to $R^{D37}$ optionally have optionally further has is preferably an alkyl group, a cycloalkyl group, an aryl group or a monovalent heterocyclic group, more preferably an alkyl group or a cycloalkyl group, and the foregoing groups optionally further have a substituent, but it is preferable that they do not further have a substituent.

In the metal complex represented by the formula Ir-1, at least one of $R^{D1}$ to $R^{D8}$ is preferably an aryl group, a monovalent heterocyclic group or a substituted amino group, and more preferably a group represented by the formula (D-A) .

In the metal complex represented by the formula Ir-2, at least one of $R^{D11}$ to $R^{D20}$ is preferably an aryl group, a monovalent heterocyclic group or a substituted amino group, and more preferably a group represented by the formula (D-A) .

In the metal complex represented by the formula Ir-3, at least one of $R^{D1}$ to $R^{D8}$ and $R^{D11}$ to $R^{D20}$ is preferably an aryl group, a monovalent heterocyclic group or a substituted amino group, and more preferably a group represented by the formula (D-A).

In the metal complex represented by the formula Ir-4, at least one of $R^{D21}$ to $R^{D26}$ is preferably an aryl group, a monovalent heterocyclic group or a substituted amino group, and more preferably a group represented by the formula (D-A) .

In the metal complex represented by the formula Ir-5, at least one of $R^{D31}$ to $R^{D37}$ is preferably an aryl group, a monovalent heterocyclic group or a substituted amino group, and more preferably a group represented by the formula (D-A) .

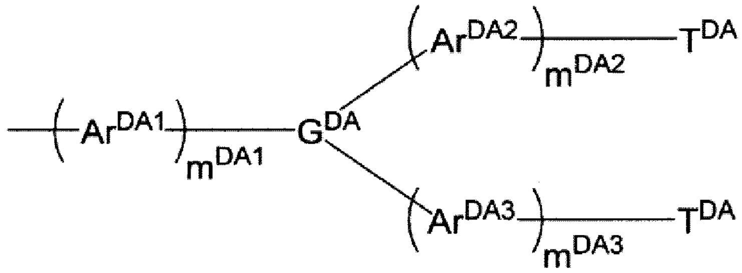

(D-A)

[wherein,
$m^{DA1}$, $m^{DA2}$ and $m^{DA3}$ each independently represent an integer of 0 or more.

$G^{DA}$ represents a nitrogen atom, a tri-valent aromatic hydrocarbon group or a tri-valent heterocyclic group, and the foregoing groups optionally have a substituent.

$Ar^{DA1}$, $Ar^{DA2}$ and $Ar^{DA3}$ each independently represent an arylene group or a divalent heterocyclic group, and the foregoing groups optionally have a substituent. When a plurality of $Ar^{DA1}$, $Ar^{DA2}$ and $Ar^{DA3}$ are present, they may be the same or different at each occurrence.

$T^{DA}$ represents an aryl group or a monovalent heterocyclic group, and the foregoing groups optionally have a substituent. A plurality of $T^{DA}$ may be the same or different.]

$m^{DA1}$, $m^{DA2}$ and $m^{DA3}$ are each usually an integer of 10 or less, preferably an integer of 5 or less, and more preferably 0 or 1. It is preferable that $m^{DA1}$, $m^{DA2}$ and $m^{DA3}$ are the same integer.

$G^{DA}$ is preferably a tri-valent aromatic hydrocarbon group or a tri-valent heterocyclic group, more preferably a group represented by the formulae (GDA-11) to (GDA-15), and the foregoing groups optionally have a substituent.

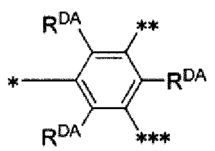
(GDA-11)

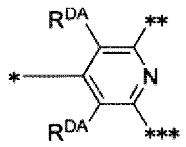
(GDA-12)

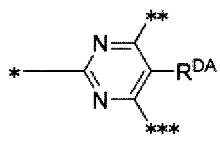
(GDA-13)

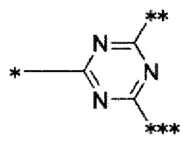
(GDA-14)

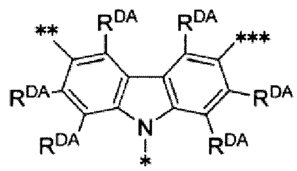
(GDA-15)

[wherein,
*, ** and *** represent bonds to $Ar^{DA1}$, $Ar^{DA2}$, $Ar^{DA3}$, respectively.

$R^{DA}$ represents a hydrogen atom, an alkyl group, a cycloalkyl group, an alkoxy group, a cycloalkoxy group, an aryl group or a monovalent heterocyclic group, and the foregoing groups optionally further have a substituent. When a plurality of $R^{DA}$ are present, they may be the same or different.]

$R^{DA}$ is preferably a hydrogen atom, an alkyl group, a cycloalkyl group, an alkoxy group or a cycloalkoxy group, more preferably a hydrogen atom, an alkyl group or a cycloalkyl group, and the foregoing groups optionally have a substituent.

$Ar^{DA1}$, $Ar^{DA2}$ and $Ar^{DA3}$ are each preferably a group represented by the formulae (ArDA-1) to (ArDA-3).

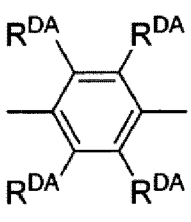
**(ArDA-1)**

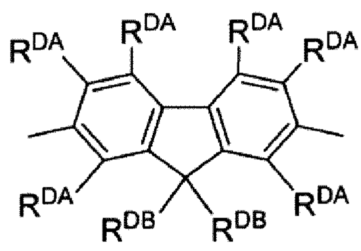
**(ArDA-2)**

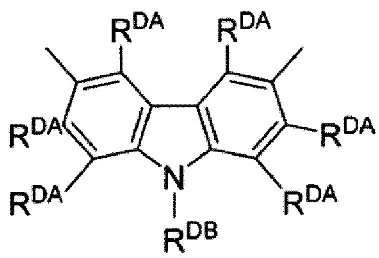
**(ArDA-3)**

[wherein,
$R^{DA}$ represents the same meaning as described above.

$R^{DB}$ represents a hydrogen atom, an alkyl group, a cycloalkyl group, an aryl group or a monovalent heterocyclic group, and the foregoing groups optionally have a substituent. When a plurality of $R^{DB}$ are present, they may be the same or different.]

$T^{DA}$ is preferably a group represented by the formulae (TDA-1) to (TDA-3).

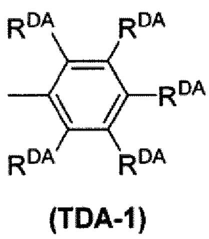
(TDA-1)

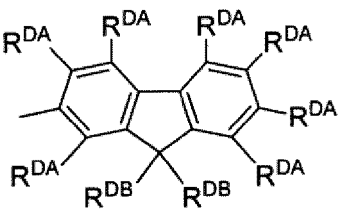
(TDA-2)

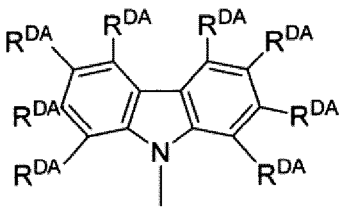
(TDA-3)

[wherein, $R^{DA}$ and $R^{DB}$ represent the same meaning as described above.]

The group represented by the formula (D-A) is preferably a group represented by the formulae (D-A1) to (D-A3).

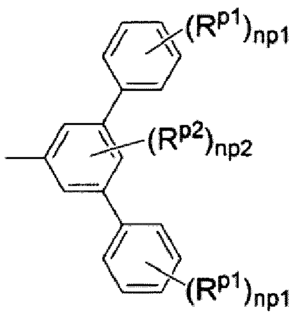
(D-A1)

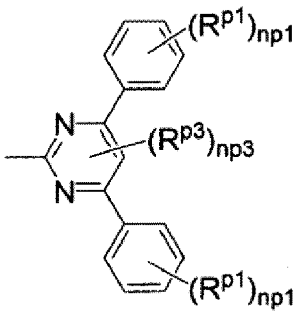
(D-A2)

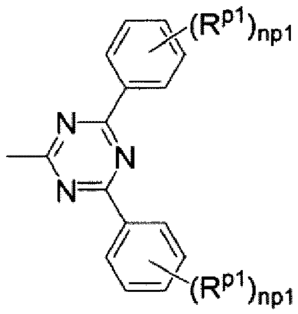
(D-A3)

[wherein,

$R^{p1}$, $R^{p2}$ and $R^{p3}$ each independently represent an alkyl group, a cycloalkyl group, an alkoxy group, a cycloalkoxy group or a halogen atom. When a plurality of $R^{p1}$ and $R^{p2}$ are present, they may be the same or different at each occurrence.

np1 represents an integer of 0 to 5, np2 represents an integer of 0 to 3, and np3 represents 0 or 1. A plurality of np1 may be the same or different.]

np1 is preferably an integer of 0 to 3, more preferably an integer of 1 to 3, and further preferably 1. np2 is preferably 0 or 1, and more preferably 0. np3 is preferably 0.

$R^{p1}$, $R^{p2}$ and RP3 are each preferably an alkyl group or a cycloalkyl group.

The preferable range and the like of the substituent which $G^{DA}$, $Ar^{DA1}$, $Ar^{DA2}$, $Ar^{DA3}$, $T^{DA}$, $R^{DA}$ and $R^{DB}$ optionally have are the same as the preferable range and the like of the substituent which a substituent which $R^{D1}$ to $R^{D8}$, $R^{D11}$ to $R^{D20}$, $R^{D21}$ to $R^{D26}$ and $R^{D31}$ to $R^{D37}$ optionally have optionally further has.

The anionic bidentate ligand represented by -$A^{D1}$---$A^{D2}$-includes, for example, ligands represented by the following formulae.

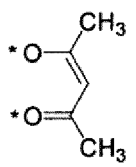
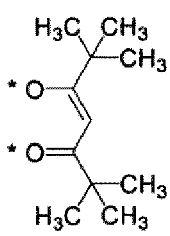
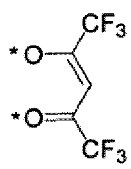
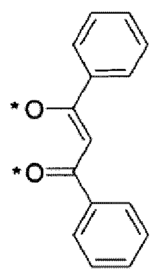
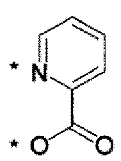
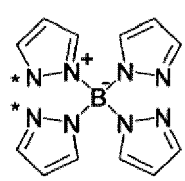

[wherein, * represents a site binding to Ir.]

The metal complex represented by the formula Ir-1 is preferably a metal complex represented by the formulae Ir-11 to Ir-13. The metal complex represented by the formula Ir-2 is preferably a metal complex represented by the formula Ir-21. The metal complex represented by the formula Ir-3 is preferably a metal complex represented by the formulae Ir-31 to Ir-33. The metal complex represented by the formula Ir-4 is preferably a metal complex represented

by the formulae Ir-41 to Ir-43. The metal complex represented by the formula Ir-5 is preferably a metal complex represented by the formulae Ir-51 to Ir-53.

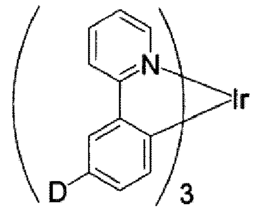

Ir-11

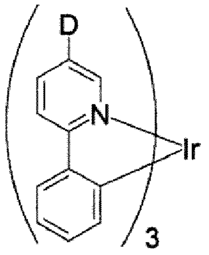

Ir-12

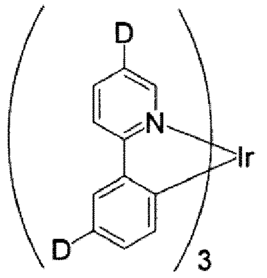

Ir-13

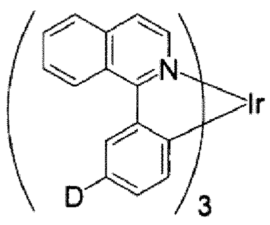

Ir-21

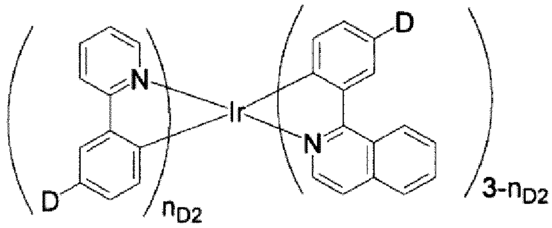

Ir-31

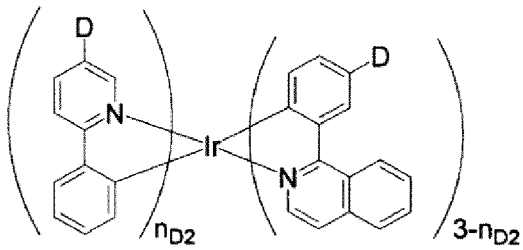

Ir-32

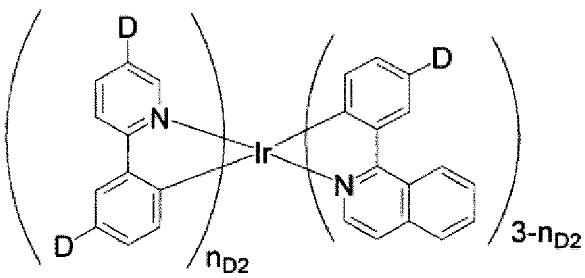

Ir-33

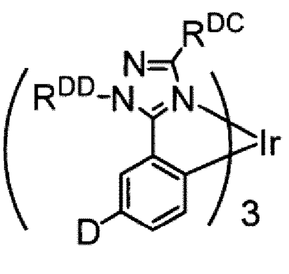

Ir-41

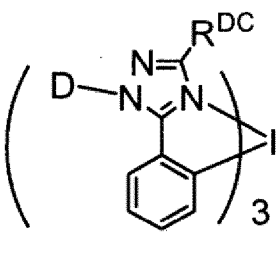

Ir-42

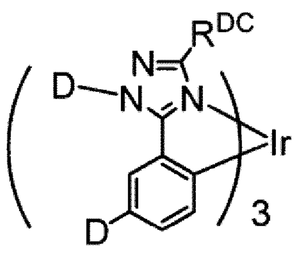

Ir-43

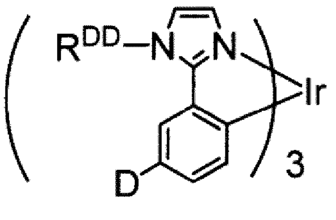

Ir-51

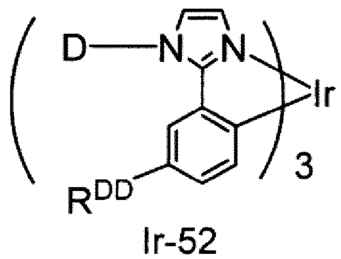

Ir-52

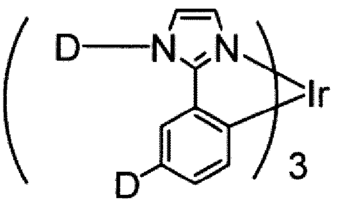

Ir-53

[wherein,

$n_{D2}$ represents 1 or 2.

D represents a group represented by the formula (D-A). A plurality of D may be the same or different.

$R^{DC}$ represents a hydrogen atom, an alkyl group, a cycloalkyl group, an aryl group or a monovalent heterocyclic group, and the foregoing groups optionally have a substituent. A plurality of $R^{DC}$ may be the same or different.

$R^{DD}$ represents an alkyl group, a cycloalkyl group, an aryl group or a monovalent heterocyclic group, and the foregoing groups optionally have a substituent. A plurality of $R^{DD}$ may be the same or different.]

The triplet light emitting complex includes, for example, metal complexes shown below.

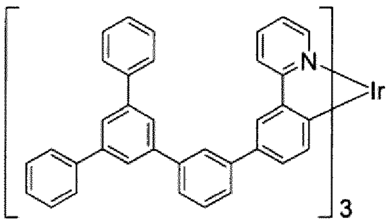

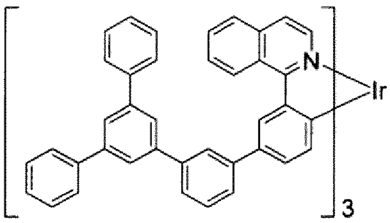

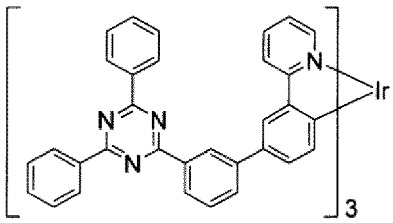

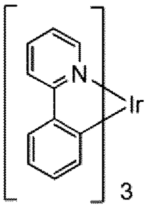

**Ir(ppy)$_3$**

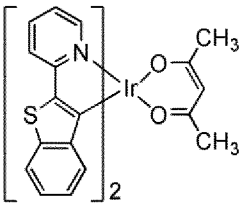

**Btp$_2$Ir(acac)**

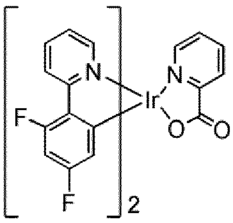

**FIrpic**

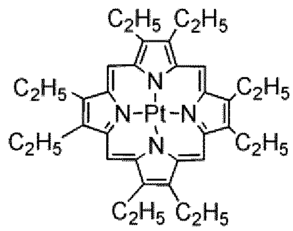

**PtOEP**

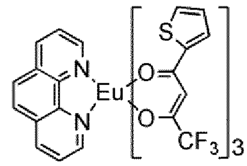

**Eu(TTA)$_3$phen**

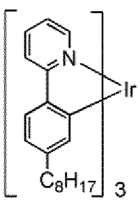

**COM-1**

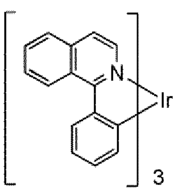

**COM-2**

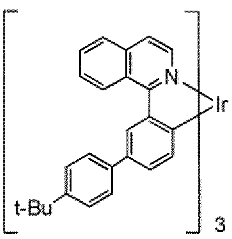

**COM-3**

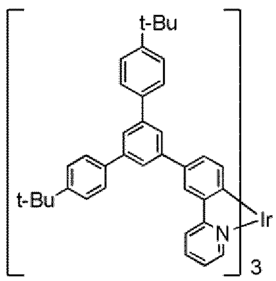

**COM-4**

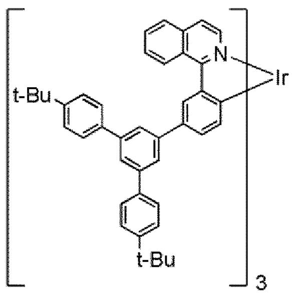

**COM-5**

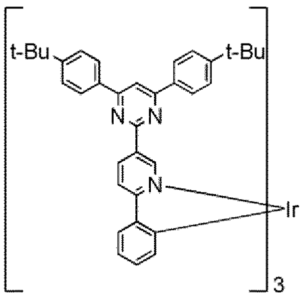

**COM-6**

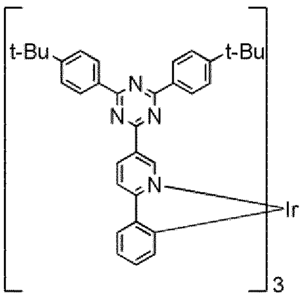

**COM-7**

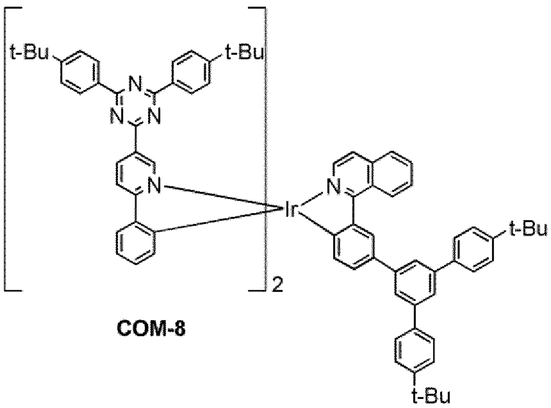

**COM-8**

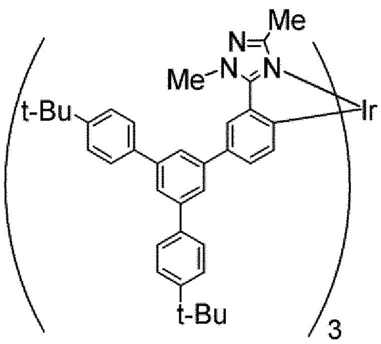

COM-9

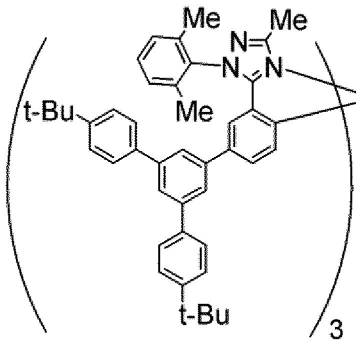

COM-10

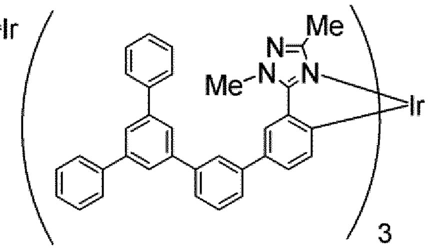

COM-11

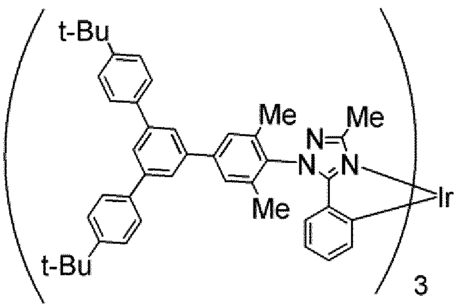

COM-12

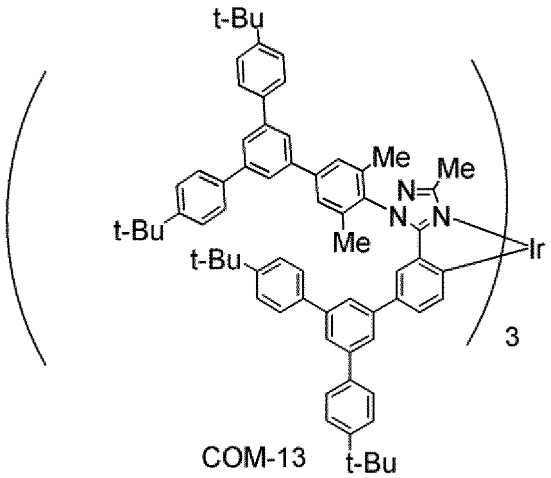

COM-13

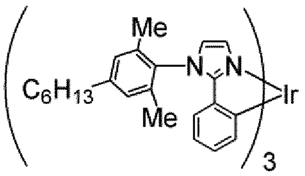

COM-14

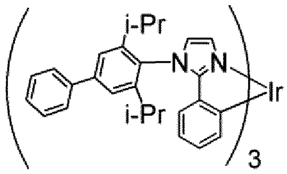

COM-15

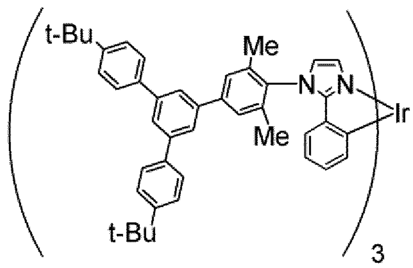

COM-16

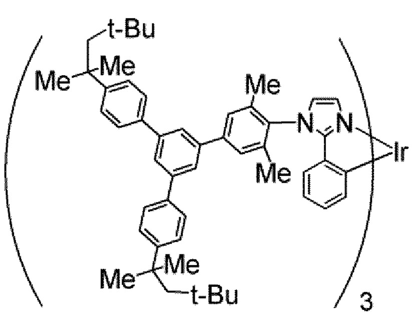

COM-17

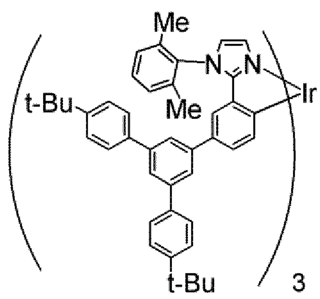

COM-18

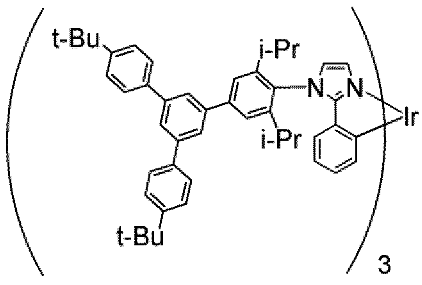

COM-19

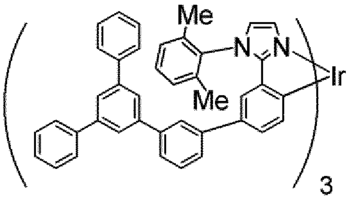

COM-20

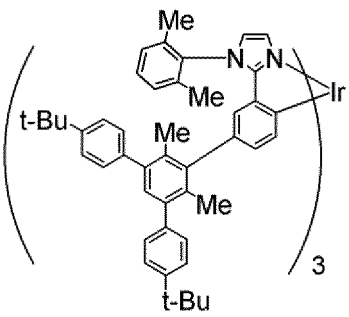

COM-21

When the above-described polymer compound and the above-described low molecular weight compound are used in combination with the above-described guest materials, the content of the above-described guest materials is usually 0.1 to 400 parts by weight with respect to 100 parts by weight of the organic EL materials (polymer compound and low molecular weight compound).

<Antioxidant>

The antioxidant may be a compound that does not inhibit light emission and charge transportation, and includes, for example, phenol type antioxidants and phosphorus-based antioxidants. It is preferable that the antioxidant is soluble in the same solvent as that for a polymer compound and a low molecular weight compound which is an organic EL material.

The compounding amount of the antioxidant is usually 0.001 to 10 parts by weight with respect to 100 parts by weight of the organic EL materials (polymer compound and low molecular weight compound). The antioxidant may be used singly or in combination of two or more.

3. Fabrication of organic EL device

The organic EL device of the present invention is preferably an organic EL device having electrodes and 2 or more (or 3 or more) organic EL material layers on a substrate. The organic EL device is produced by applying and drying a solution containing a solvent including a solvent A having a boiling point under 1 atom of 250°C or higher and organic EL materials to form 1 or more organic EL material layers, and adjusting the proportion $X_A$ ($\mu$g/ $cm^3$) of the content ($\mu$g) of the solvent A in the organic EL device to the volume ($cm^3$) of the organic EL material in the organic EL device so as to satisfy the formula (1):

$$5 < X_A \leq 2650 \qquad (1).$$

<Solving including a solvent A having a boiling point under 1 atom of 250°C or higher>

The solvent including a solvent A having a boiling point under 1 atom of 250°C or higher includes solvents containing a solvent A having a boiling point under 1 atom of 250°C or higher described in the above-mentioned section of "2. Organic EL device", and another solvent B (hereinafter, described also as "a solvent B") as required.

The boiling point range of the solvent B may be appropriately determined in consideration of workability and the like, and is usually 50°C or higher and lower than 250°C, preferably 80°C or higher and lower than 250°C, more preferably 100°C or higher and lower than 250°C, further preferably 120°C or higher and lower than 250°C, and particularly preferably 160°C or higher and lower than 250°C. In order to improve the flatness of the film, two or more organic solvents having different boiling points may be used in combination as the solvent B.

As the solvent B, organic solvents capable of dissolving or uniformly dispersing organic EL materials (the above-described polymer compounds and/or low molecular weight compounds, or the like) are preferred.

Of the solvent B, a halogenated hydrocarbon solvent, an aliphatic hydrocarbon solvent, an aromatic hydrocarbon solvent, an aliphatic ether solvent, an aromatic ether solvent, an alcohol solvent, a ketone solvent, an amide solvent, an ester solvent and a carbonate solvent are preferable.

The halogenated hydrocarbon solvent includes, for example, dichloroethane, trichloroethane, chlorobenzene and dichlorobenzene.

The aliphatic hydrocarbon solvent includes, for example, cyclohexane, methylcyclohexane, pentane, hexane,

heptane, octane, nonane, decane, dodecane and bicyclohexyl.

The aromatic hydrocarbon solvent includes, for example, toluene, xylene, ethylbenzene, trimethylbenzene, tetramethylbenzene, propylbenzene, butylbenzene, pentylbenzene, cyclopentylbenzene, methylcyclopentylbenzene, hexylbenzene, cyclohexylbenzene, methylcyclohexylbenzene, heptylbenzene, cycloheptylbenzene and methylcycloheptylbenzene.

The aliphatic ether solvent includes, for example, diisopropyl ether, methylbutyl ether, dibutyl ether, tetrahydrofuran, dioxane, ethylene glycol dimethyl ether, ethylene glycol diethyl ether, diethylene glycol dimethyl ether and triethylene glycol dimethyl ether.

The aromatic ether solvent includes, for example, anisole, dimethoxybenzene, trimethoxybenzene, ethoxybenzene, propoxybenzene, butoxybenzene, methylpropoxybenzene, butoxybenzene, methoxytoluene, ethoxytoluene, methoxynaphthalene, ethoxynaphthalene and phenoxytoluene.

The alcohol solvent includes, for example, ethanol, propanol, butanol, pentanol, cyclopentanol, hexanol, cyclohexanol, heptanol, octanol, benzyl alcohol, phenylethanol, ethylene glycol, propylene glycol, diethylene glycol monomethyl ether and propanediol.

The ketone solvent includes, for example, acetone, methyl ethyl ketone, methyl butyl ketone, dibutyl ketone, cyclohexanone, methylcyclohexanone, hexanone, octanone, nonanone, phenylacetone, acetylacetone, acetonylacetone, acetophenone, methyl naphthyl ketone and isophorone.

The amide solvent includes, for example, N-methylpyrrolidone, N-ethylpyrrolidone, N,N-dimethylacetamide, N,N-dimethylformamide and 1,3-dimethyl-2-imidazolidinone.

The ester solvent includes, for example, butyl acetate, ethyl acetate, propyl acetate, pentyl acetate, ethyl propionate, ethyl butyrate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, propyl formate, propyl lactate, ethyl phenylacetate, ethyl benzoate, β-propiolactone, γ-butyrolactone and δ-valerolactone.

The carbonate solvent includes, for example, dimethyl carbonate, diethyl carbonate, ethylene carbonate and propylene carbonate.

The solvent including a solvent A having a boiling point under 1 atom of 250°C or higher is desirably a solvent with which the solubility of the organic EL material (polymer compound and/or low molecular weight compound) is within a desirable range. It is preferable that the solvent is a solvent with which the solubility of the organic EL material is usually 0.01% by weight or more, particularly 0.1% by weight or more. The solvent may be a single solvent or a mixed solvent combining two or more solvents.

For example, in the case of a single solvent, the solubility of the organic EL material is not necessarily in the above range, and even when the solubility of the material is less than 0.01% by weight in the case of a single solvent, the solubility thereof is usually 0.01% by weight or more, preferably 0.01% by weight or more in the case of a mixed solvent in which another organic solvent is used in combination.

When the solvent including a solvent A contains a solvent A and a solvent B, the compounding ratio thereof can be widely set within the range in which the effect of the present invention is exhibited. The compounding ratio of the solvent A and the solvent B is usually 10 to 10000 parts by weight of the solvent B with respect to 1 part by weight of the solvent A.

<Organic EL device fabrication method>

Each of organic EL material layers in the organic EL device can be fabricated by, for example, a spin coat method, a casting method, a microgravure coat method, a gravure coat method, a bar coat method, a roll coat method, a wire bar coat method, a dip coat method, a spray coat method, a screen printing method, a flexo printing method, an offset printing method, an inkjet printing method, a capillary coat method and a nozzle coat method using an ink.

The thickness of each layer in the organic EL device is usually 1 nm to 10 μm.

For formation of each layer in the organic EL device, a composition (ink) containing at least on organic EL material selected from the group consisting of, for example, a hole transporting material, a hole injection material, an electron transporting material, an electron injection material and a light emitting material, and the above-described solvent including a solvent A having a boiling point under 1 atom of 250°C or higher can be used. This ink is suitable for fabrication of an organic EL device using a printing method such as an inkjet printing method, a nozzle printing method and the like. The organic EL material is selected from the above-described polymer compounds and low molecular weight compounds.

The viscosity of an ink may be adjusted depending on the kind of a printing method, and is preferably 1 to 20 mPa·s at 25°C for preventing clogging and flight bending during discharging when applied a printing method in which a solution passes through a discharge device such as in an inkjet print method and the like.

The compounding amount of the solvent including a solvent A having a boiling point under 1 atom of 250°C or

higher in the ink is usually 1000 to 100000 parts by weight with respect to 100 parts by weight of the organic EL material.

<Drying method>

Drying of the applied film obtained by an inkjet printing method can be appropriately selected depending on the type of each layer. Usually, it can be heated at 100 to 250°C, preferably 150 to 200°C for 5 to 60 minutes under an atmospheric atmosphere or an atmosphere of an inert gas (nitrogen, argon, etc.). Further, it may be heated under normal pressure (1 atm) or reduced pressure (100 Pa to 0.1 MPa). The temperature, pressure and time in this drying step can be set so that the solvent B having a low boiling point is removed and a predetermined amount of the solvent A having a high boiling point remains in each layer. That is, by this drying step, the ratio $X_A$ of the solvent A to the volume of the organic EL material in the organic EL device can be adjusted so as to satisfy the formula (1).

Layers of the typical organic EL material layer will be described below.

[Hole transporting layer]

In the hole transporting layer, usually, a hole transporting material is used. The hole transporting material is selected from low molecular weight compounds and polymer compounds described above.

The polymer compound includes, for example, polyvinylcarbazole and derivatives thereof; polyarylenes having an aromatic amine structure in the side chain or main chain, and derivatives thereof. The polymer compound may be a compound to which an electron-accepting site is attached. The electron-accepting site includes, for example, fullerene, tetrafluorotetracyanoquinodimethane, tetracyanoethylene, trinitrofluorenone and the like.

The compounding amount of the hole transporting material in the above-described ink is usually 1 to 400 parts by weight with respect to 100 parts by weight of all solvents. Alternatively, the content of the hole transporting material with respect to the total weight of the ink is usually 0.1 to 30% by weight.

The hole transporting material may be used singly or in combination of two or more.

[Electron transporting layer]

In the electron transporting layer, usually, an electron transporting material is used. The electron transporting material is selected from low molecular weight compounds and polymer compounds described above.

The low molecular weight compound includes, for example, metal complexes having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene, and derivatives thereof. The polymer compound may be doped with a metal.

In the above-described ink, the compounding amount of the electron transporting material is usually , 1 to 400 parts by weight with respect to 100 parts by weight of all solvents. Alternatively, the content of the electron transporting material with respect to the total weight of the ink is usually 0.1 to 30% by weight.

The electron transporting material may be used singly or in combination of two or more.

[Hole injection layer and electron injection layer]

As the hole injection layer and the electron injection layer, usually a hole injection material and an electron injection material are used. The hole injection material and the electron injection material are each selected from low molecular weight compounds and polymer compounds.

The low molecular weight compound includes, for example, metallophthalocyanines such as copper phthalocyanine and the like; carbon; oxides of metals such as molybdenum, tungsten and the like; and metal fluorides such as lithium fluoride, sodium fluoride, cesium fluoride, potassium fluoride and the like.

The polymer compound includes electrically conductive polymers such as, for example, polyaniline, polythiophene, polypyrrole, polyphenylenevinylene, polythienylenevinylene, polyquinoline and polyquinoxaline, and derivatives thereof; polymers containing an aromatic amine structure in the main chain or side chain, and the like.

In the above-described ink, the compounding amounts of the hole injection material and the electron injection material are each usually 1 to 400 parts by weight with respect to 100 parts by weight of all solvents. Alternatively, the contents of the hole injection material and the electron injection material with respect to the total weight of the ink are usually 0.1 to 30% by weight.

The hole injection material and the electron injection material each may be used singly or in combination of two or more.

[Ion doping]

When the hole injection material or the electron injection material contains an electrically conductive polymer, the electric conductivity of the electrically conductive polymer is preferably $1 \times 10^{-5}$ S/cm to $1 \times 10^{3}$ S/cm. The electrically conductive polymer can be doped with an appropriate amount of ions, so as to keep the electric conductivity of the electrically conductive polymer within such a range.

The type of ions to be doped is an anion in the case of the hole injection material, and a cation in the case of the electron injection material. The anion includes, for example, a polystyrenesulfonate ion, an alkylbenzenesulfonate ion and a camphor sulfonate ion. The cation includes, for example, a lithium ion, a sodium ion, a potassium ion and a tetrabutylammonium ion.

[Substrate/electrode]

The substrate in the organic EL device may be a substrate on which an electrode can be formed and which does not chemically change in forming an organic layer, and is a substrate made of a material such as, for example, glass, plastic, silicon and the like. In the case of an opaque substrate, it is preferable that an electrode farthest from the substrate is transparent or semitransparent.

The material of the anode includes, for example, electrically conductive metal oxides and semitransparent metals, preferably includes indium oxide, zinc oxide, tin oxide; electrically conductive compounds such as indiumtin-oxide (ITO), indium-zinc-oxide and the like; argentinepalladium-copper (APC) complex; NESA, gold, platinum, silver and copper.

The material of the cathode includes, for example, metals such as lithium, sodium, potassium, rubidium, cesium, beryllium, magnesium, calcium, strontium, barium, aluminum, zinc, indium and the like; alloys composed of two or more of them; alloys composed of at least one of them and at least one of silver, copper, manganese, titanium, cobalt, nickel, tungsten and tin; and graphite and graphite intercalation compounds.

Th anode and the cathode each may have a laminated structure composed of two or more layers.

[Application of organic EL device]

The organic EL device of the present invention is useful for applications such as, for example, display, illumination and the like.

EXAMPLES

The present invention will be illustrated in detail using examples and comparative examples below, but the present invention is not limited to these examples.

Synthesis Example 1 (Synthesis of phosphorescent compound E1)

A phosphorescent compound E1 was synthesized according to a method described in JP-A No. 2006-188673.

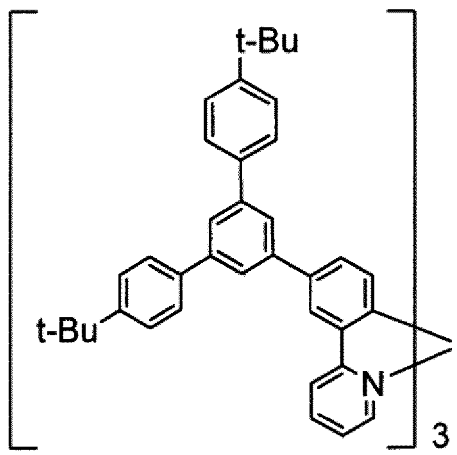

phosphorescent compound E1

Synthesis Example 2 (Synthesis of polymer compound P1)

A polymer compound P1 was synthesized as described below.

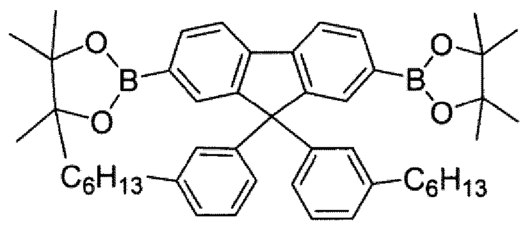

CM1

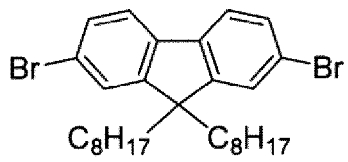

CM2

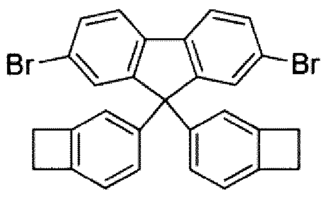

CM3

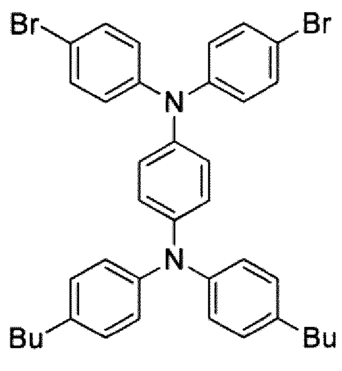

CM4

A monomer CM1 was synthesized according to a method described in JP-A No. 2011-174061.
A monomer CM2 was synthesized according to a method described in International Publication WO2002/045184.
A monomer CM3 was synthesized according to a method described in JP-A No. 2008-106241.
A monomer CM4 was synthesized according to a method described in JP-A No. 2003-226744.
An inert gas atmosphere was prepared in a reaction vessel, then, a monomer CM1 (185 g), a monomer CM2 (35.9 g), a monomer CM3 (20.1 g), a monomer CM4 (104 g), dichlorobis(triphenylphosphine)palladium (177 mg) and toluene (4.3 kg) were added, and the mixture was heated at 100°C.
Thereafter, a 20% by weight tetraethylammonium hydroxide aqueous solution (873 g) was dropped into this, and the mixture was stirred at 100°C for 5 hours.

Thereafter, to this were added phenylboronic acid (3.08 g) and toluene (120 g), and the mixture was stirred at 100°C for 14 hours.

An aqueous layer was removed from the resultant reaction liquid, then, to this were added a sodium diethyldithiacarbamate aqueous solution and toluene, and the mixture was stirred at 40°C for 3 hours. Thereafter, the mixture was cooled down to room temperature, and the aqueous layer was removed to obtain an organic layer. The resultant organic layer was washed with 10% by weight hydrochloric acid twice, with a 3% by weight ammonia aqueous solution twice, and with water twice. The washed organic layer was purified by passing through an alumina column and a silica gel column in this order. The resultant purified liquid was dropped into methanol and stirred, to generate a precipitate. The resultant precipitate was filtrated and dried, to obtain 204 g of a polymer compound P1. The polymer compound P1 had an Mn of $6.7 \times 10^4$ and an Mw of $2.3 \times 10^5$.

The polystyrene-equivalent number-average molecular weight (Mn) and weight-average molecular weight (Mw) were measured using HLC-8320GPC manufactured by Tosoh Corp. The measurement conditions of GPC are shown below.

[Table 1]

| | |
|---|---|
| column | two columns of PLgel 10 μm MIXED-B 300×7.5mm (manufactured by Agilent) |
| mobile phase | THF (for HPLC; no stabilizer contained) |
| flow rate | sample side 1.0 mL/min, reference side 1/4=0.25 mL/min |
| injection amount | 10 μL |
| detector | UV 228 nm |

The polymer compound P1 is a copolymer constituted of a constitutional unit derived from the monomer CM1, a constitutional unit derived from the monomer CM2, a constitutional unit derived from the monomer CM3 and a constitutional unit derived from the monomer CM4 at a molar ratio of 50:12.5:7.5:30, according to the theoretical values calculated from the amounts of the charged raw materials.

Synthesis Example 3 (Synthesis of polymer compound P2)

A polymer compound P2 was synthesized as described below.

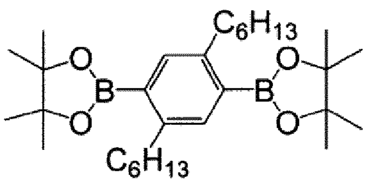
CM5

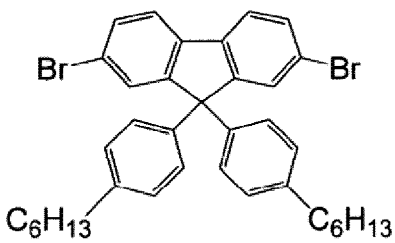
CM9

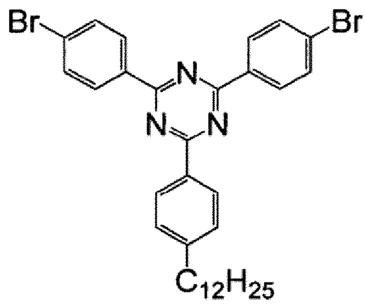
CM12

A monomer CM5 was synthesized according to a method described in JP-A No. 2010-189630.

A monomer CM9 was synthesized according to a method described in International Publication WO2012/86671.

A monomer CM12 was synthesized according to a method described in JP-A No. 2010-189630.

A polymer compound P2 was synthesized according to a method described in JP-A No. 2012-36388 using the monomer CM5, the monomer CM9 and the monomer CM12. The polymer compound P2 had an Mn of $9.1 \times 10^4$ and an Mw of $2.3 \times 10^5$.

The polystyrene-equivalent number-average molecular weight (Mn) and weight-average molecular weight (Mw) were measured using HLC-8320GPC manufactured by Tosoh Corp. The measurement conditions of GPC are as in Synthesis Example 2.

The polymer compound P2 is a copolymer constituted of a constitutional unit derived from the monomer CM5, a constitutional unit derived from the monomer CM9 and a constitutional unit derived from the monomer CM12 at a molar ratio of 50:40:10, according to the theoretical values calculated from the amounts of the charged raw materials.

Preparation Example 1 (Preparation of composition 1)

The phosphorescent compound E1 and the polymer compound P2 (weight ratio = 45/55) were dissolved in a solvent composed of xylene (boiling point: 144°C) and n-hexyl benzoate (boiling point: 272°C)(weight ratio = 99.9/0.1), to prepare a liquid composition 1 in which the content of the phosphorescent compound E1 and the polymer compound P2 was 2.1% by weight.

Preparation Example 2 (Preparation of composition 2)

The phosphorescent compound E1 and the polymer compound P2 (weight ratio = 45/55) were dissolved in a solvent composed of xylene (boiling point: 144°C) and n-hexyl benzoate (boiling point: 272°C)(weight ratio = 99.0/1.0), to prepare a liquid composition 2 in which the content of the phosphorescent compound E1 and the polymer compound P2 was 2.1% by weight.

Preparation Example 3 (Preparation of composition 3)

The phosphorescent compound E1 and the polymer compound P2 (weight ratio = 45/55) were dissolved in a solvent composed of xylene (boiling point: 144°C) and n-hexyl benzoate (boiling point: 272°C)(weight ratio = 90/10), to prepare a liquid composition 3 in which the content of the phosphorescent compound E1 and the polymer compound P2 was 2.1% by weight.

Preparation Example 4 (Preparation of composition 4)

The phosphorescent compound E1 and the polymer compound P2 (weight ratio = 45/55) were dissolved in a solvent composed of xylene (boiling point: 144°C) and n-hexyl benzoate (boiling point: 272°C)(weight ratio = 50/50), to prepare a liquid composition 4 in which the content of the phosphorescent compound E1 and the polymer compound P2 was 2.1% by weight.

Example D1 (Fabrication and evaluation of organic EL device D1)

(Setting of thickness of each layer)

For the thickness of a hole injection layer, a hole transporting layer and a light emitting layer to be formed by a spin coat method, conditions were set so that each single layer formed on a glass substrate by a spin coat method in advance was confirmed by a contact-type step gauge (manufactured by KLA-Tencor, P-16+), to obtain a predetermined thickness.

(Formation of anode and hole injection layer)

An ITO film with a thickness of 45 nm was attached to a glass substrate by a sputtering method, to form an anode. On the substrate, a hole injection material was spin-coated to form a hole injection layer with a thickness of 60 nm. This was heated on a hot plate at 230°C for 15 minutes under an air atmosphere, then, allowed to cool naturally to room temperature.

(Formation of hole transporting layer)

The polymer compound P1 was dissolved in xylene at a concentration of 0.6% by weight. The resultant xylene solution was spin-coated to form a film with a thickness of 20 nm on the hole injection layer, and the film was heated at 190°C for 60 minutes under a nitrogen gas atmosphere, to form a hole transporting layer.

(Formation of light emitting layer)

The composition 1 was spin-coated to form a film with a thickness of 80 nm on the hole transporting layer, and the film was heated at 150°C for 10 minutes under a nitrogen gas atmosphere, to form a light emitting layer.

(Formation of cathode)

The substrate carrying the light emitting layer formed thereon was placed in a vapor deposition machine, and

the inner pressure was reduced to $1.0 \times 10^{-4}$ Pa or less, then, sodium fluoride was vapor-deposited with a thickness of 3 nm on the light emitting layer and, then, aluminum was vapor-deposited with a thickness of 100 nm on the sodium fluoride layer, as the cathode. After vapor deposition, a sealing layer was formed with a glass substrate under a nitrogen gas atmosphere, to fabricate an organic EL device D1. Under this constitution, a space exists between the anode, the cathode and each layer of the organic EL device D1, and the glass substrate used for forming the sealing layer. Since formation of the sealing layer is performed under a nitrogen gas atmosphere, the space is filled with a nitrogen gas.

Voltage was applied to the organic EL device D1, to observe EL light emission (green color). The current value was set so that the initial luminance was 3000 cd/$m^2$, then, the device was driven at constant current, and the time until the luminance decreased to 95% of the initial luminance (hereinafter, referred to also as "LT95") was measured, to find a time of 43.0 hours.

Example D2 (Fabrication and evaluation of organic EL device D2)

An organic EL device D2 was fabricated in the same manner as in Example D1, except that the composition 1 in Example D1 was changed to the composition 2.

Voltage was applied to the resultant organic EL device D2, to observe EL light emission (green color). The current value was set so that the initial luminance was 3000 cd/$m^2$, then, the device was driven at constant current, and LT95 was measured, to find a time of 43.5 hours.

Example D3 (Fabrication and evaluation of organic EL device D3)

An organic EL device D3 was fabricated in the same manner as in Example D1, except that the composition 1 in Example D1 was changed to the composition 3.

Voltage was applied to the resultant organic EL device D3, to observe EL light emission (green color). The current value was set so that the initial luminance was 3000 cd/$m^2$, then, the device was driven at constant current, and LT95 was measured, to find a time of 35.0 hours.

Example D4 (Fabrication and evaluation of organic EL device D4)

An organic EL device D4 was fabricated in the same manner as in Example D1, except that the composition 1 in Example D1 was changed to the composition 4.

Voltage was applied to the resultant organic EL device D4, to observe EL light emission (green color). The current value was set so that the initial luminance was 3000 cd/$m^2$, then, the device was driven at constant current, and LT95 was measured, to find a time of 28.8 hours.

Comparative Example CD1 (Fabrication and evaluation of organic EL device CD1)

An organic EL device CD1 was fabricated in the same manner as in Example D2, except that the temperature was changed from 150°C to 200°C in the step of forming a light emitting layer in Example D2.

Voltage was applied to the resultant organic EL device CD1, to observe EL light emission (green color). The current value was set so that the initial luminance was 3000 cd/$m^2$, then, the device was driven at constant current, and LT95 was measured, to find a time of 22.8 hours.

The results described above are shown in Table 2. An LT95 of 25 hours or more was evaluated as preferable luminance life.

[Table 2]

| | Examples | | | | Comparative Example |
|---|---|---|---|---|---|
| organic EL device | D1 | D2 | D3 | D4 | CD1 |
| cathode | Al/NaF | Al/NaF | Al/NaF | Al/NaF | Al/NaF |
| light emitting layer | composition 1 (150°C, 10 min) | composition 2 (150°C, 10 min) | composition 3 (150°C, 10 min) | composition 4 (150°C, 10 min) | composition 2 (200°C, 10 min) |

(continued)

| | Examples | | | | Comparative Example |
|---|---|---|---|---|---|
| organic EL device | D1 | D2 | D3 | D4 | CD1 |
| cathode | Al/NaF | Al/NaF | Al/NaF | Al/NaF | Al/NaF |
| hole transporting layer | polymer compound P1 (190°C, 60 min) | polymer compound P1 (190°C, 60 min) | polymer compound P1 (190°C, 60 min) | polymer compound P1 (190°C, 60 min) | polymer compound P1 (190°C, 60 min) |
| hole injection layer | hole injection material (230°C, 15 min) | hole injection material (230°C, 15 min) | hole injection material (230°C, 15 min) | hole injection material (230°C, 15 min) | hole injection material (230°C, 15 min) |
| anode | ITO film | ITO film | ITO film | ITO film | ITO film |
| substrate | glass substrate | glass substrate | glass substrate | glass substrate | glass substrate |
| LT95 (h) | 43.0 | 43.5 | 35.0 | 28.8 | 22.8 |

Fabrication and measurement of residual solvent amount measurement method sample S1

<Residual solvent amount measurement method>

The amount of a solvent remaining in an organic EL device (hereinafter, described as residual solvent amount) was measured by a head space gas chromatography method. It is constituted of a head space sampler (HS40 manufactured by Turbo Matrix), a gas chromatography (GC-2010 manufactured by Shimadzu Corp.) and a mass spectrometer (QP-2010 Plus manufactured by Shimadzu Corp.). The respective measurement conditions are shown below.

■ head space sampler conditions

head space mode: constant
vial bending: ON
GC cycle time: 60 minutes
pressurization time: 3 minutes
lifting time: 0.5 minutes
heat retention time: 30 minutes
injection time: 0.5 minutes
zone temperature set: O/N/T
oven temperature: 200°C
needle temperature: 210°C
HS carrier gas pressure: 120 kPa

■ gas chromatography conditions

column: DB-5 (diameter 0.25 mmΦ × length 30 m × thickness 0.25 μm)
column oven temperature: 60°C
vaporizing chamber temperature: 250°C

■ mass spectrometer conditions

ion source temperature: 240°C
interface temperature: 240°C
detector gain mode: absolute value

detector gain: 1.00 kV

A calibration curve consisting of the amount of n-hexyl benzoate (boiling point: 272°C) or 3-phenoxytoluene (boiling point: 272°C) and the AREA area was obtained previously by a head space gas chromatography method under the conditions described above, and the amount of the residual solvent contained in the organic EL device was quantified based on the above calibration curve.

Example S1 (Fabrication and measurement of residual solvent amount measurement sample S1)

(Formation of anode and hole injection layer)

An ITO film with a thickness of 45 nm was attached to a glass substrate by a sputtering method, to form an anode. On the substrate, a hole injection material was spin-coated to form a hole injection layer with a thickness of 60 nm. This was heated on a hot plate at 230°C for 15 minutes under an air atmosphere, then, allowed to cool naturally to room temperature.

(Formation of hole transporting layer)

The polymer compound P1 was dissolved in xylene at a concentration of 0.6% by weight. The resultant xylene solution was spin-coated to form a film with a thickness of 20 nm on the hole injection layer, and the film was heated at 190°C for 60 minutes under a nitrogen gas atmosphere, to form a hole transporting layer.

(Formation of light emitting layer)

The composition 1 was spin-coated to form a film with a thickness of 80 nm on the hole transporting layer, and the film was heated at 150°C for 10 minutes under a nitrogen gas atmosphere, to form a light emitting layer.

(Fabrication of residual solvent amount measurement sample S1)

The front surface, back surface and side surface of the organic EL device were wiped with a cloth containing an organic solvent having low boiling point such as acetone or the like to remove impurified adhered to the surfaces, and dried, then, the glass substrate was cut so that the film area was 1.4 cm × 1.4 cm, to fabricate a residual solvent amount measurement sample S1. Under this constitution, the thickness of the organic EL material of the residual solvent amount measurement sample S1 was 160 nm combining 60 nm of the hole injection layer, 20 nm of the hole transporting layer and 80 nm of the light emitting layer. The cut residual solvent amount measurement sample S1 was further pulverized with pliers to a size that can be enclosed in a vial for head space, then, enclosed in the vial for head space, and the residual solvent amount was measured by the above-described method, to find an amount of 19 $\mu g/ cm^3$.

Example S2 (Fabrication and measurement of residual solvent amount measurement sample S2)

A residual solvent amount measurement sample S2 was fabricated in the same manner as in Example S1, except that the composition 1 in Example S1 was changed to the composition 2. When the residual solvent amount was measured by the method described above, it was 58 $\mu g/ cm^3$.

Example S3 (Fabrication and measurement of residual solvent amount measurement sample S3)

A residual solvent amount measurement sample S3 was fabricated in the same manner as in Example S1, except that the composition 1 in Example S1 was changed to the composition 3. When the residual solvent amount was measured by the method described above, it was 84 $\mu g/ cm^3$.

Example S4 (Fabrication and measurement of residual solvent amount measurement sample S4)

A residual solvent amount measurement sample S4 was fabricated in the same manner as in Example S1, except that the composition 1 in Example S1 was changed to the composition 4. When the residual solvent amount was measured by the method described above, it was 132 $\mu g/ cm^3$.

Comparative Example CS1 (Fabrication and measurement of residual solvent amount measurement sample CS1)

A residual solvent amount measurement sample CS1 was fabricated in the same manner as in Example S2, except that the temperature was changed from 150°C to 200°C in the step of forming a light emitting layer in Example S2. When the residual solvent amount was measured by the method described above, it was 5 μg/ $cm^3$.

The results described above are shown in Table 3.

[Table 3]

| | Examples | | | | Comparative Example |
|---|---|---|---|---|---|
| residual solvent amount measurement sample | S1 | S2 | S3 | S4 | CS1 |
| light emitting layer | composition 1 | composition 2 | composition 3 | composition 4 | composition 2 |
| | (150°C, 10 min) | (150°C, 10 min) | (150°C, 10 min) | (150°C, 10 min) | (200°C, 10 min) |
| hole transporting layer | polymer compound P1 (190°C, 60 min) | polymer compound P1 (190°C, 60 min) | polymer compound P1 (190°C, 60 min) | polymer compound P1 (190°C, 60 min) | polymer compound P1 (190°C, 60 min) |
| hole injection layer | hole injection material (230°C, 15 min) | hole injection material (230°C, 15 min) | hole injection material (230°C, 15 min) | hole injection material (230°C, 15 min) | hole injection material (230°C, 15 min) |
| anode | ITO film | ITO film | ITO film | ITO film | ITO film |
| substrate | glass substrate | glass substrate | glass substrate | glass substrate | glass substrate |
| residual solvent amount (μg/$cm^3$) | 19 | 58 | 84 | 132 | 5 |

Synthesis Example 4 (Synthesis of phosphorescent compound E2)

The phosphorescent compound E2 was synthesized with reference to a method described in International Publication WO2006/121811 and JP-A No. 2013-048190.

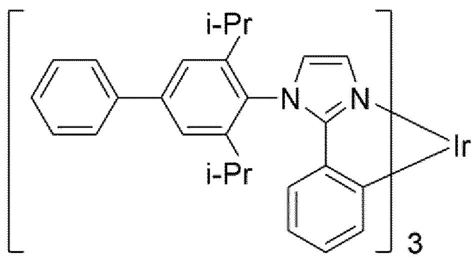

phosphorescent compound E2

Synthesis Example 5 (Synthesis of phosphorescent compound E3)

The phosphorescent compound E3 was synthesized with reference to a method described in JP-A No. 2006-188673.

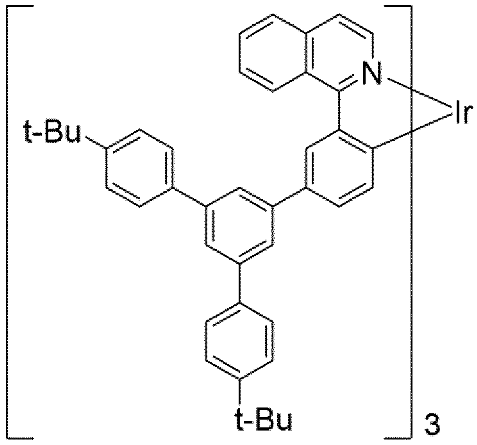

phosphorescent compound E3

Synthesis Example 6 (Synthesis of low molecular weight compound E4)

The low molecular weight compound E4 was purchased from Luminescence Technology Corp.

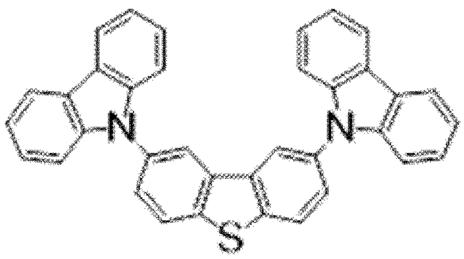

low molecular weight compound E4

Preparation Example 5 (Preparation of composition 5)

The phosphorescent compound E1, the phosphorescent compound E2, the phosphorescent compound E3 and the low molecular weight compound E4 (weight ratio: E1/E2/E3/E4 = 1/0.1/25/73.9) were dissolved in a solvent composed of toluene (boiling point: 111°C) and 3-phenoxytoluene (boiling point: 272°C)(weight ratio: toluene/3-phenoxytoluene = 99/1), to prepare a liquid composition 5 in which the content of the phosphorescent compound E1, the phosphorescent compound E2, the phosphorescent compound E3 and the low molecular weight compound E4 was 3.0% by weight.

Preparation Example 6 (Preparation of composition 6)

A liquid composition 6 was prepared in the same manner as for the liquid composition 5, except that the materials were dissolved in a solvent composed of toluene (boiling point: 111°C) and 3-phenoxytoluene (boiling point: 272°C)(weight ratio: toluene/3-phenoxytoluene=99.9/0.1).

Example D5 (Fabrication and evaluation of organic EL device D5)

An organic EL device D5 was fabricated in the same manner as in Example D1, except that the composition 1 in Example D1 was changed to the composition 5 and the temperature was changed from 150°C to 170°C in the step of forming a light emitting layer.

Voltage was applied to the resultant organic EL device D5, to observe EL light emission (white color). The current value was set so that the initial luminance was 1000 cd/m$^2$, then, the device was driven at constant current, and LT95 was measured, to find a time of 29.3 hours.

Example D6 (Fabrication and evaluation of organic EL device D6)

An organic EL device D6 was fabricated in the same manner as in Example D5, except that the composition 5 in Example D5 was changed to the composition 6.
Voltage was applied to the resultant organic EL device D6, to observe EL light emission (white color). The current value was set so that the initial luminance was 1000 cd/$m^2$, then, the device was driven at constant current, and LT95 was measured, to find a time of 34.0 hours.

Example D7 (Fabrication and evaluation of organic EL device D7)

An organic EL device D7 was fabricated in the same manner as in Example D6, except that the temperature was changed from 170°C to 130°C in the step of forming a light emitting layer in Example D6.
Voltage was applied to the resultant organic EL device D7, to observe EL light emission (white color). The current value was set so that the initial luminance was 1000 cd/$m^2$, then, the device was driven at constant current, and LT95 was measured, to find a time of 32.5 hours.

Comparative Example CD2 (Fabrication and evaluation of organic EL device CD2)

An organic EL device CD2 was fabricated in the same manner as in Example D5, except that the temperature was changed from 170°C to 130°C in the step of forming a light emitting layer in Example D5.
Voltage was applied to the resultant organic EL device CD2, to observe EL light emission (white color). The current value was set so that the initial luminance was 1000 cd/$m^2$, then, the device was driven at constant current, and LT95 was measured, to find a time of 11.4 hours.
The results described above are shown in Table 4.

[Table 4]

| | Examples | | | Comparative Example |
|---|---|---|---|---|
| organic EL device | D5 | D6 | D7 | CD2 |
| cathode | Al/NaF | Al/NaF | Al/NaF | Al/NaF |
| light emitting layer | composition 5 (170°C, 10 min) | composition 6 (170°C, 10 min) | composition 6 (130°C, 10 min) | composition 5 (130°C, 10 min) |
| hole transporting layer | polymer compound P1 (190°C, 60 min) | polymer compound P1 (190°C, 60 min) | polymer compound P1 (190°C, 60 min) | polymer compound P1 (190°C, 60 min) |
| hole injection layer | hole injection material (230°C, 15 min) | hole injection material (230°C, 15 min) | hole injection material (230°C, 15 min) | hole injection material (230°C, 15 min) |
| anode | ITO film | ITO film | ITO film | ITO film |
| substrate | glass substrate | glass substrate | glass substrate | glass substrate |
| LT95 (h) | 29.3 | 34.0 | 32.5 | 11.4 |

Example S5 (Fabrication and measurement of residual solvent amount measurement sample S5)

A residual solvent amount measurement sample S5 was fabricated in the same manner as in Example S1, except that the composition in Example S1 was changed to the composition 5 and the temperature was changed from 150°C to 170°C in the step of forming a light emitting layer. When the residual solvent amount was measured by the method described above, it was 388 μg/ $cm^3$.

Example S6 (Fabrication and measurement of residual solvent amount measurement sample S6)

A residual solvent amount measurement sample S6 was fabricated in the same manner as in Example S5, except that the composition 5 in Example S5 was changed to the composition 6. When the residual solvent amount was

measured by the method described above, it was 160 μg/ $cm^3$.

Example S7 (Fabrication and measurement of residual solvent amount measurement sample S7)

A residual solvent amount measurement sample S7 was fabricated in the same manner as in Example S6, except that the temperature was changed from 170°C to 130°C in the step of forming a light emitting layer in Example S6. When the residual solvent amount was measured by the method described above, it was 1761 μg/ $cm^3$.

Comparative Example CS2 (Fabrication and measurement of residual solvent amount measurement sample CS2)

A residual solvent amount measurement sample CS2 was fabricated in the same manner as in Example S5, except that the temperature was changed from 170°C to 130°C in the step of forming a light emitting layer in Example S5. When the residual solvent amount was measured by the method described above, it was 2697 μg/ $cm^3$.

The results described above are shown in Table 5.

[Table 5]

| | Examples | | | Comparative Example |
|---|---|---|---|---|
| residual solvent amount measurement sample | S5 | S6 | S7 | CS2 |
| light emitting layer | composition 5 (170°C, 10 min) | composition 6 (170°C, 10 min) | composition 6 (130°C, 10 min) | composition 5 (130°C, 10 min) |
| hole transporting layer | polymer compound P1 (190°C, 60 min) | polymer compound P1 (190°C, 60 min) | polymer compound P1 (190°C, 60 min) | polymer compound P1 (190°C, 60 min) |
| hole injection layer | hole injection material (230°C, 15 min) | hole injection material (230°C, 15 min) | hole injection material (230°C, 15 min) | hole injection material (230°C, 15 min) |
| anode | ITO film | ITO film | ITO film | ITO film |
| substrate | glass substrate | glass substrate | glass substrate | glass substrate |
| residual solvent amount (μg/$cm^3$) | 338 | 160 | 1761 | 2697 |

It was confirmed from Table 2, Table 3, Table 4 and Table 5 that LT95 is remarkably high when the proportion (residual solvent amount) of the content (μg) of a high boiling point solvent (n-hexyl benzoate or 3-phenoxytoluene) to the volume ($cm^3$) of the organic EL material (hole injection layer, hole transporting layer and light emitting layer) in the organic EL device is over 5 and 2650 or less.

Industrial Applicability

The organic EL device of the present invention is useful for applications such as display, illumination and the like since the organic EL device is excellent in luminance life among properties of the organic EL device.

## Claims

1. An organic EL device comprising an organic EL material and a solvent A having a boiling point under 1 atom of 250°C or higher, wherein the proportion $X_A$ (μg/$cm^3$) of the content (μg) of the solvent A to the volume ($cm^3$) of the organic EL material in the organic EL device satisfies the formula (1):

$$5 < X_A \leq 2650 \qquad (1).$$

**2.** The organic EL device according to Claim 1, wherein the organic EL device has a substrate, an electrode and two or more organic EL material layers, and at least one organic EL material layer contains the solvent A.

**3.** The organic EL device according to Claim 2, wherein the organic EL material layer contains a hole injection layer, a hole transporting layer and a light emitting layer, and the solvent A is contained at least in the light emitting layer.

**4.** The organic EL device according to any one of Clams 1 to 3, wherein the solvent A is at least one selected from the group consisting of a hydrocarbon solvent, an alcohol solvent, an ester solvent, a ketone solvent, an ether solvent, a solvent containing a nitrogen atom, and a solvent containing a sulfur atom.

**5.** The organic EL device according to any one of Claims 1 to 4, wherein the organic EL material is at least one selected from the group consisting of
a compound represented by the formula (Y):

$$\textbf{-[-Ar}^{Y1}\textbf{-]-} \qquad \textbf{(Y)}$$

wherein, $Ar^{Y1}$ represents an arylene group, a divalent heterocyclic group, or a divalent group in which at least one arylene group and at least one divalent heterocyclic group are bonded directly, and the foregoing groups optionally have a substituent,
a compound represented by the formula (H-1):

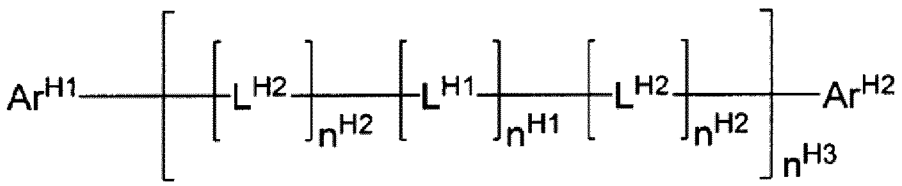

**(H-1)**

wherein,

$Ar^{H1}$ and $Ar^{H2}$ each independently represent an aryl group or a monovalent heterocyclic group, and the foregoing groups optionally have a substituent,
$n^{H1}$ and $n^{H2}$ each independently represent 0 or 1, and when a plurality of $n^{H1}$ are present, they may be the same or different, and a plurality of $n^{H2}$ may be the same or different,
$n^{H3}$ represents an integer of 0 or more and 10 or less,
$L^{H1}$ represents an arylene group, a divalent heterocyclic group or a group represented by $-[C(R^{H11})_2]n^{H11}-$, and the foregoing groups optionally have a substituent, and when a plurality of $L^{H1}$ are present, they may be the same or different, $n^{H11}$ represents an integer of 1 or more and 10 or less, $R^{H11}$ represents a hydrogen atom, an alkyl group, a cycloalkyl group, an alkoxy group, a cycloalkoxy group, an aryl group or a monovalent heterocyclic group, and the foregoing groups optionally have a substituent, and a plurality of $R^{H11}$ may be the same or different and may be combined together to form a ring together with carbon atoms to which they are attached,
$L^{H2}$ represents a group represented by $-N(-L^{H21}-R^{H21})-$, and when a plurality of $L^{H2}$ are present, they may be the same or different, $L^{H21}$ represents a single bond, an arylene group or a divalent heterocyclic group, and the foregoing groups optionally have a substituent, $R^{H21}$ represents a hydrogen atom, an alkyl group, a cycloalkyl group, an aryl group or a monovalent heterocyclic group, and the foregoing groups optionally have a substituent, and

a compound represented by the formulae (Ir-1) to (Ir-5) :

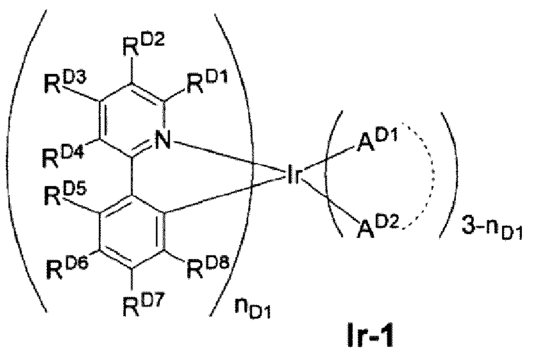

**Ir-1**

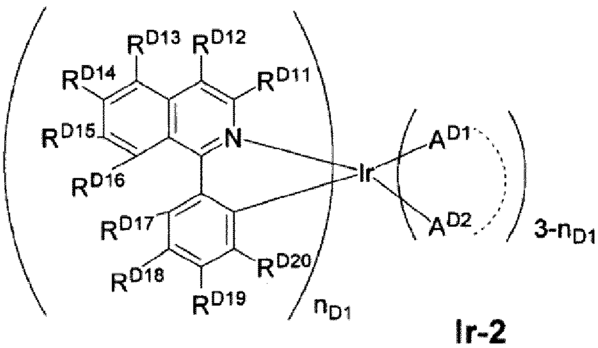

**Ir-2**

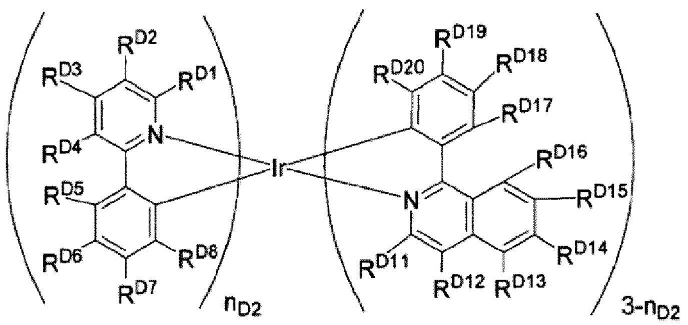

**Ir-3**

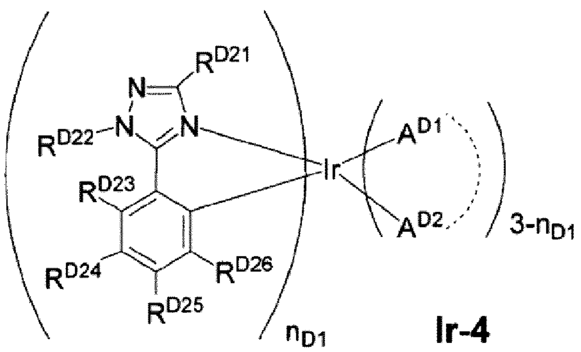

**Ir-4**

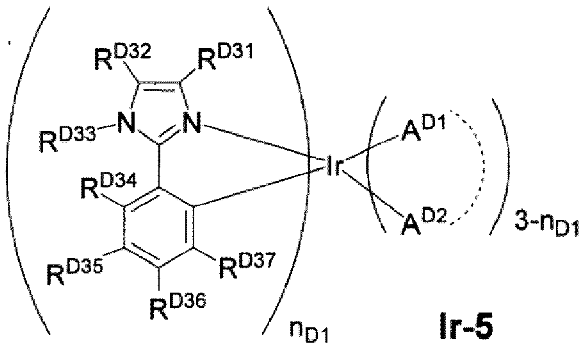

**Ir-5**

wherein,

$R^{D1}$ to $R^{D8}$, $R^{D11}$ to $R^{D20}$, $R^{D21}$ to $R^{D26}$ and $R^{D31}$ to $R^{D37}$ each independently represent a hydrogen atom, an alkyl group, a cycloalkyl group, an alkoxy group, a cycloalkoxy group, an aryl group, an aryloxy group, a monovalent heterocyclic group or a halogen atom, and the foregoing groups optionally have a substituent, and when a plurality of $R^{D1}$ to $R^{D8}$, $R^{D11}$ to $R^{D20}$, $R^{D21}$ to $R^{D26}$ and $R^{D31}$ to $R^{D37}$ are present, they may be the same or different at each occurrence,

$-A^{D1}$---$A^{D2}$- represents an anionic bidentate ligand, $A^{D1}$ and $A^{D2}$ each independently represent a carbon atom, an oxygen atom or a nitrogen atom bonding to an iridium atom, and these atoms may be ring constituent atoms, and when a plurality of $-A^{D1}$---$A^{D2}$-are present, they may be the same or different,

$n_{D1}$ represents 1, 2 or 3, and $n_{D2}$ represents 1 or 2.

**6.** A method of producing an organic EL device having an electrode and two or more organic EL material layers on a substrate, wherein a composition comprising a solvent containing a solvent A having a boiling point under 1 atom of 250°C or higher and an organic EL material is applied and dried to form one or more organic EL material layers, and the proportion $X_A$ (μg/cm$^3$) of the content (pg) of the solvent A in the organic EL device to the volume (cm$^3$) of the organic EL material in the organic EL device is adjusted so as to satisfy the formula (1):

$$5 < X_A \leq 2650 \quad (1).$$

## INTERNATIONAL SEARCH REPORT

International application No. PCT/JP2019/022476

A. CLASSIFICATION OF SUBJECT MATTER
Int.Cl. H05B33/10(2006.01)i, H01L51/50(2006.01)i
According to International Patent Classification (IPC) or to both national classification and IPC

B. FIELDS SEARCHED
Minimum documentation searched (classification system followed by classification symbols)
Int.Cl. H05B33/10, H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2016-181648 A (SEIKO EPSON CORP.) 13 October 2016, paragraphs [0041]-[0044], [0057]-[0068], [0072], [0105]-[0141] & US 2018/0062078 A1 (paragraphs [0071]-[0074], [0089]-[0111], [0116], [0154]-[0190]) & WO 2016/152028 A1 & EP 3276696 A1 & TW 201641620 A & KR 10-2017-0110722 A & CN 107431137 A | 1-6 |
| X | WO 2017/059943 A1 (MERCK PATENT GMBH) 13 April 2017, page 80, line 6 to page 85, line 2 & US 2019/0062578 A1 & JP 2018-537808 A & EP 3359623 A1 & CN 108138042 A & KR 10-2018-0067593 A & TW 201728701 A | 1-6 |
| X | WO 2017/140404 A1 (MERCK PATENT GMBH) 24 August 2017, page 74, line 3 to page 78, line 31 & US 2019/0044067 A1 & EP 3417033 A1 & KR 10-2018-0110125 A | 1-6 |
| A | JP 2018-016681 A (SEIKO EPSON CORP.) 01 February 2018, entire text, all drawings & US 2018/0030296 A1 (entire text, all drawings) | 1-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 05 August 2019 (05.08.2019) | 20 August 2019 (20.08.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2019/022476

C (Continuation). DOCUMENTS CONSIDERED TO BE RELEVANT

| Category* | Citation of document, with indication, where appropriate, of the relevant passages | Relevant to claim No. |
|---|---|---|
| A | JP 2015-149501 A (KONICA MINOLTA, INC.) 20 August 2015, entire text, all drawings (Family: none) | 1-6 |
| A | JP 2012-531012 A (UNIVERSAL DISPLAY CORPORATION) 06 December 2012, entire text, all drawings & US 2010/0323464 A1 (entire text, all drawings) & US 2012/0270349 A1 & WO 2010/147818 A1 & EP 2962338 A1 & KR 10-2012-0037409 A & CN 102460759 A & CN 107104185 A & TW 201107435 A | 1-6 |
| A | JP 2006-156824 A (SEIKO EPSON CORP.) 15 June 2006, entire text, all drawings & US 2006/0113897 A1 (entire text, all drawings) & KR 10-2006-0060541 A & CN 1784103 A & TW 200621078 A | 1-6 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006128325 A
- WO 2007063754 A
- WO 2008056746 A
- WO 2011032686 A
- WO 2012096263 A
- JP 2009227663 A
- JP 2010275255 A
- JP 2006188673 A
- JP 2011174061 A
- WO 2002045184 A
- JP 2008106241 A
- JP 2003226744 A
- JP 2010189630 A
- WO 201286671 A
- JP 2012036388 A
- WO 2006121811 A
- JP 2013048190 A